(19) Europäisches Patentamt
European Patent Office
Office européen des brevets

(11) **EP 2 766 936 B1**

(12) **EUROPEAN PATENT SPECIFICATION**

(45) Date of publication and mention of the grant of the patent:
**18.09.2019 Bulletin 2019/38**

(51) Int Cl.:
*H01L 33/50* (2010.01)　　　*H01L 33/48* (2010.01)
*F21K 9/64* (2016.01)　　　*H01L 33/58* (2010.01)
*F21V 9/30* (2018.01)　　　*F21Y 115/10* (2016.01)
*F21K 9/232* (2016.01)　　　*H01L 25/075* (2006.01)

(21) Application number: **12839621.5**

(22) Date of filing: **12.10.2012**

(86) International application number:
**PCT/US2012/059892**

(87) International publication number:
**WO 2013/056009 (18.04.2013 Gazette 2013/16)**

(54) **LIGHT EMITTING DEVICE WITH PHOTOLUMINESCENCE WAVELENGTH CONVERSION COMPONENT**

LICHTEMITTIERENDE VORRICHTUNG MIT FOTOLUMINESZENZ-WELLENLÄNGENUMWANDLUNGSKOMPONENTE

DISPOSITIF ÉLECTROLUMINESCENT AVEC ÉLÉMENT DE CONVERSION DE LONGUEUR D'ONDE DE PHOTOLUMINESCENCE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **13.10.2011 US 201113273215**
**13.10.2011 US 201113273212**
**13.10.2011 US 201113273217**

(43) Date of publication of application:
**20.08.2014 Bulletin 2014/34**

(73) Proprietor: **Intematix Corporation**
**Fremont CA 94538 (US)**

(72) Inventors:
• **DAI, Bing**
**Fremont, CA 94536 (US)**
• **YUAN, Xianglong**
**Fremont, CA 94539 (US)**
• **WANG, Gang**
**Milpitas, CA 95035 (US)**
• **EDWARDS, Charles**
**Pleasanton, CA 94566 (US)**

(74) Representative: **Birdi, Sandeep Singh et al**
**24 Ibbetson Oval**
**Churwell**
**Morley, Leeds LS27 7RY (GB)**

(56) References cited:
EP-A2- 2 113 949　　　WO-A1-2007/085977
WO-A1-2008/043519　　KR-A- 20070 065 486
KR-A- 20090 017 346　　US-A1- 2002 180 351
US-A1- 2011 001 151　　US-A1- 2011 006 316
US-A1- 2011 147 778　　US-A1- 2011 147 778
US-B1- 6 653 765

**Description**

FIELD OF THE INVENTION

This invention relates to solid-state light emitting devices and lamps that use a remotely positioned photoluminescence wavelength conversion component to generate a desired color of light.

BACKGROUND OF THE INVENTION

White light emitting LEDs ("white LEDs") are known and are a relatively recent innovation. It was not until LEDs emitting in the blue/ultraviolet part of the electromagnetic spectrum were developed that it became practical to develop white light sources based on LEDs. As taught, for example in US 5,998,925, white LEDs include one or more one or more photoluminescence materials (e.g. phosphor materials), which absorb a portion of the radiation emitted by the LED and re-emit light of a different color (wavelength). Typically, the LED chip or die generates blue light and the phosphor(s) absorbs a percentage of the blue light and re-emits yellow light or a combination of green and red light, green and yellow light, green and orange or yellow and red light. The portion of the blue light generated by the LED that is not absorbed by the phosphor material combined with the light emitted by the phosphor provides light which appears to the eye as being nearly white in color. Alternatively, the LED chip or die may generate ultraviolet (UV) light, in which phosphor(s) to absorb the UV light to re-emit a combination of different colors of photoluminescence light that appear white to the human eye.

Due to their long operating life expectancy (>50,000 hours) and high luminous efficacy (70 lumens per watt and higher) high brightness white LEDs are increasingly being used to replace conventional fluorescent, compact fluorescent and incandescent light sources.

Typically the phosphor material is mixed with light transmissive materials, such as silicone or epoxy material, and the mixture applied to the light emitting surface of the LED die. It is also known to provide the phosphor material as a layer on, or incorporate the phosphor material within, an optical component, a phosphor wavelength conversion component, that is located remotely to the LED die ("remote phosphor" LED devices).

One issue with remote phosphor devices is the non-white color appearance of the device in its OFF state. During the ON state of the LED device, the LED chip or die generates blue light and the phosphor(s) absorbs a percentage of the blue light and re-emits yellow light or a combination of green and red light, green and yellow light, green and orange, or yellow and red light. The portion of the blue light generated by the LED that is not absorbed by the phosphor combined with the light emitted by the phosphor provides light which appears to the human eye as being nearly white in color. However, for a remote phosphor device in its OFF state, the absence of the blue light that would otherwise be produced by the LED in the ON state causes the device to have a yellowish, yellow-orange, or orange-color appearance. A potential consumer or purchaser of such devices that is seeking a white-appearing light may be quite confused by the yellowish, yellow-orange, or orange-color appearance of such devices in the marketplace, since the device on a store shelf is in its OFF state. This may be off-putting or undesirable to the potential purchasers and hence cause loss of sales to target customers.

Another problem with remote phosphor devices can be the variation in color of emitted light with emission angle. In particular, such devices are subject to perceptible non-uniformity in color when viewed from different angles. Such visually distinctive color differences are unacceptable for many commercial uses, particularly for the high-end lighting that often employ LED lighting devices.

Yet another problem with using phosphor materials is that they are relatively costly, and hence correspond to a significant portion of the costs for producing phosphor-based LED devices. For a non-remote phosphor device, the phosphor material in a LED light is typically mixed with a light transmissive material such as a silicone or epoxy material and the mixture directly applied to the light emitting surface of the LED die. This results in a relatively small layer of phosphor materials placed directly on the LED die, that is nevertheless still costly to produce in part because of the significant costs of the phosphor materials. A remote phosphor device typically uses a much larger layer of phosphor materials as compared to the non-remote phosphor device. Because of its larger size, a much greater amount of phosphor is normally required to manufacture such remote phosphor LED devices. As a result, the costs are correspondingly greater as well to provide the increased amount of phosphor materials needed for such remote phosphor LED devices.

Therefore, there is a need for improved approaches to implement LED lighting apparatuses that maintains the desired color properties of the devices, but without requiring the large quantities of photoluminescence materials (e.g. phosphor materials) that are required in the prior approaches. In addition, there is a need for an improved approach to implement LED lighting apparatuses which addresses perceptible variations in color of emitted light with emission angle, and which also addresses the non-white color appearance of the LED lighting apparatuses while in an OFF state.

US2011147778 discloses a light emitting device which includes a semiconductor light emitting element including a semiconductor layer that emits primary light; and a fluorescent material layer disposed on the light emitting side of the semiconductor light emitting element, that absorbs a part of the primary light and emits secondary light having a wavelength longer than that of the primary light; and emits light of blended color of the primary light and the secondary light of the light emitting element. It further includes a scattering layer in which particles are dispersed in a transparent medium.

EP2113949 discloses a light emitting device, especially a phosphor-converted white light device, including both nanoparticles and light scattering particles proximate to the light source. Nanoparticles having a high index of refraction are dispersed throughout a wavelength conversion layer to adjust the index of refraction of the layer for improved light extraction. Light scattering particles may be dispersed in the wavelength conversion layer and/or in a surrounding medium.

US6653765 discloses a light source that includes a light emitting component, such as a UV/blue light emitting diode or laser diode, a layer of a light scattering material, and a layer of a phosphor material. The phosphor material converts a portion of the light emitted by the light emitting component to light of a longer wavelength, such as yellow light. The scattering material scatters the light emitted by the light emitting component and/or the light converted by the phosphor.

US2011006316 discloses a display, a lighting device and a method for manufacturing the lighting device. The lighting device comprises a substrate, an electrode layer, a plurality of light source units and a light scattering layer, which is covered by a transparent layer and a reflector layer. A yellow phosphor layer is disposed above the reflector layer.

WO2007085977 discloses a light-emitting device comprising a solid-state light source, at least one conversion element and a light- scattering element, wherein the solid-state light source is provided to emit a first part of a primary radiation for entry into the light-scattering element and a second part of a primary radiation for entry into the conversion element for at least partial conversion into at least one secondary radiation.

US2011001151 discloses an LED package that comprises at least one LED that emits LED light in an LED emission profile. The LED package includes regions of scattering particles with the different regions scattering light primarily at a target wavelength or primarily within a target wavelength range. The location of the regions and scattering properties are based at least partially on the LED emission profile. The regions scatter their target wavelength of LED light.

## SUMMARY OF THE INVENTION

Embodiments of the invention concern light emitting devices and lamps comprising one or more solid-state light sources, typically LEDs, that are operable to generate excitation radiation (typically blue light) and a remote wavelength conversion component, containing one or more excitable photoluminescence materials (e.g. phosphor materials), that is operable to convert at least a portion of the excitation radiation to light of a different wavelength. When using a blue light radiation source, the emission product of the device comprises the combined light generated by the source and the wavelength conversion component and is typically configured to appear white in color. The wavelength conversion component comprises a light transmissive substrate such as a polymer or glass having a wavelength conversion layer comprising particles of the excitable photoluminescence material (such as phosphor) and a light diffusing layer comprising particles of a light diffractive material (such as titanium dioxide). In accordance with some embodiments of the invention, the wavelength conversion and light diffusing layers are in direct contact with each other and are preferably deposited by screen printing or slot die coating. As used herein, "direct contact" means that there are no intervening layers or air gaps.

One benefit of this approach is that by selecting an appropriate particle size and concentration per unit area of the light diffractive material, an improvement is obtained in the white color appearance of a LED device in its OFF state. Another benefit is an improvement to the color uniformity of emitted light from an LED device for emission angles over a $\pm 60°$ range from the emission axis. Moreover the use of a light diffusing layer having an appropriate particle size and concentration per unit area of the light diffractive material can substantially reduce the quantity of phosphor material required to generate a selected color of emitted light, since the light diffusing layer increases the probability that a photon will result in the generation of photoluminescence light by directing light back into the wavelength conversion layer. Therefore, inclusion of a diffusing layer in direct contact with the wavelength conversion layer can reduce the quantity of phosphor material required to generate a given color emission product, e.g. by up to 40%. In one embodiment the particle size of the light diffractive material is selected such that excitation radiation generated by the source is scattered more than light generated by the one or more phosphor materials.

According to an aspect of the present invention, there is provided a light emitting device, comprising at least one solid-state light emitter operable to generate blue excitation light; and a wavelength conversion component positioned remotely to the at least one solid-state light emitter, said wavelength conversion component comprising: at least one blue light excitable photoluminescence material; and a light scattering material, wherein the light scattering material has an average particle size that is selected such that the light scattering material will scatter blue excitation light relatively more than the light scattering material will scatter light generated by the at least one photoluminescence material, wherein the at least one photoluminescence material is located in a wavelength conversion layer and the light scattering material is located in a light diffusing layer different from the wavelength conversion layer, and wherein the light scattering material has an average particle size in a range 100nm to 150nm and the wavelength conversion layer faces the at least one solid-state light emitter such that, in operation, the diffusing layer decreases the probability of externally originating photons from interacting with the at least one photoluminescence material thereby improving an OFF state white appearance of component of the light emitting device. Preferably the light scattering material scatters the excitation light at least twice as much as light generated by the at least one photoluminescence material. Where the excitation light comprises blue light the light scattering material advantageously has an average particle size that is less than about 150nm.

The light scattering material advantageously comprises titanium dioxide, barium sulfate, magnesium oxide, silicon dioxide or aluminum oxide.

The at least one photoluminescence material is located in a wavelength conversion layer and the light scattering material is located in a diffusing layer. Preferably the wavelength conversion layer and the light diffusing layer are in direct contact with each other to minimize optical losses between layers.

Typically the wavelength conversion layer comprises a mixture of the at least one phosphor material and a light transmissive binder and the light diffusing layer comprises a mixture of the light scattering material and the light transmissive binder. To minimize optical losses the same light transmissive material is used for both layers. The light transmissive binder can comprise a curable liquid polymer such as a polymer resin, a monomer resin, an acrylic, an epoxy, a silicone or a fluorinated polymer. The wavelength conversion and light diffusing layers are deposited using a method selected from the group consisting of: screen printing, slot die coating, spin coating, roller coating, drawdown coating and doctor blading.

To reduce the variation in emitted light color with emission angle the weight loading of light diffractive material to binder is in a range 7% to 35% and more preferably in a range 10% to 20%.

In some embodiments the wavelength conversion layer and the light diffusing layer are substantially planar. In other embodiments the wavelength conversion layer and/or light diffusing layer can be 3-dimensional and comprise a dome or elongated dome shape. In yet further embodiments the light diffusing layer comprises a hollow 3-densional shape and the wavelength conversion layer fills a volume formed beneath the dome or elongated dome shapes.

To reduce photoluminescence material usage both the at least one photoluminescence material and the light scattering material are located in a wavelength conversion layer.

There is disclosed light scattering material having an average particle size in a range $1\mu m$ to $50\mu m$ and preferably in a range $10\mu m$ to $20\mu m$.

In some embodiments the at least one photoluminescence material is deposited onto a light transmissive substrate. In other embodiments the at least one photoluminescence material can be incorporated within the light transmissive substrate and homogeneously distributed throughout the volume of the substrate. The light transmissive substrate can comprise a polymer such as a polycarbonate or an acrylic or a glass material.

There is disclosed a light emitting device, comprising: at least one solid-state light emitter operable to generate excitation light; at least one photoluminescence material; and a light scattering material, wherein the light scattering material has an average particle size that is selected such that the light scattering material will scatter excitation light from a radiation source relatively more than the light scattering material will scatter light generated by the at least one photoluminescence material.

In preferred embodiments the average particle size of the light scattering material is selected to improve an OFF state white appearance of the light emitting device. Alternatively and/ or in addition the average particle size of the light scattering material can be selected to obtain substantially uniform color for emitted light from the light emitting device for emission angles over a $\pm60°$ range from an emission axis.

In some embodiments a weight loading of the light scattering material to a binder is in a range 7% to 35% and preferably in a range 10% to 20%.

Where the excitation light comprises blue light the light scattering material is advantageously selected such that it scatters the blue light at least twice as much as light generated by the at least one photoluminescence material. Typically in such a device the light scattering material has an average particle size that is less than about 150nm.

There is disclosed a wavelength conversion component for a light emitting device comprising at least one light emitting solid-state radiation source, comprises a light transmissive substrate having a wavelength conversion layer comprising particles of at least one photoluminescence material and a light diffusing layer comprising particles of a light diffractive material; and wherein the layers are in direct contact with each other. Preferably the wavelength conversion layer comprises a mixture of at least one phosphor material and a light transmissive binder while the light diffusing layer comprises a mixture of the light diffractive material and a light transmissive binder. To minimize optical losses at the interface of the layers it is preferred that the layers comprise the same transmissive binder. The binder can comprise a curable liquid polymer such as a polymer resin, a monomer resin, an acrylic, an epoxy, a silicone or a fluorinated polymer. The binder is preferably UV or thermally curable.

To reduce the variation in emitted light color with emission angle the weight loading of light diffractive material to binder is in a range 7% to 35% and more preferably in a range 10% to 20%. The wavelength conversion and light diffusing layers are preferably deposited by screen printing though they can be deposited using other deposition techniques such as spin coating or doctor blading. The light diffractive material preferably comprises titanium dioxide ($TiO_2$)

though it can comprise other materials such as barium sulfate ($BaSO_4$), magnesium oxide (MgO), silicon dioxide ($SiO_2$) or aluminum oxide ($Al_2O_3$).

There is disclosed light diffractive material having an average particle size in a range $1\mu m$ to $50\mu m$ and more preferably in a range $10\mu m$ to $20\mu m$. In other arrangements the light diffractive material has a particle size that is selected such that the particles will scatter excitation radiation relatively more than they will scatter light generated by the at least one photoluminescence material. For example, for blue light radiation sources, the light diffractive particle size can be selected such that the particles will scatter blue light relatively at least twice as much as they will scatter light generated by the at least one phosphor material. Such a light diffusing layer ensures that a higher proportion of the blue light emitted from the wavelength conversion layer will be scattered and directed by the light diffractive material back into the wavelength conversion layer increasing the probability of the photon interacting with a phosphor material particle and resulting in the generation of photoluminescence light. At the same time, phosphor generated light can pass through the diffusing layer with a lower probability of being scattered. Since the diffusing layer increases the probability of blue photons interacting with a phosphor material particle, less phosphor material can be used to generate a selected emission color. Such an arrangement can also increase luminous efficacy of the wavelength conversion component/device. Preferably the light diffractive material has an average particle size of less than about 150nm where the excitation radiation comprises blue light.

The light transmissive substrate can comprise any material that is substantially transmissive to visible light (380nm to 740nm) and typically comprises a polymer material such as a polycarbonate or an acrylic. Alternatively the substrate can comprise a glass.

The concept of a wavelength conversion component having a light diffusing layer composed of light diffractive particles that preferentially scatter light corresponding to wavelengths generated by the LEDs compared with light of wavelengths generated by the phosphor material is considered inventive in its own right. According to a further aspect of the invention a wavelength conversion component for a light emitting device comprising at least one blue light emitting solid-state light source, comprises a wavelength layer comprising particles of at least one phosphor material and a light diffusing layer comprising particles of a light diffractive material; wherein the light diffractive particle size is selected such that the particles will scatter excitation radiation relatively more than they will scatter light generated by the at least one phosphor material.

To increase the CRI (Color Rendering Index) of light generated by the device the device can further comprise at least one solid-state light source operable to generate red light.

According to further embodiments of the invention wavelength conversion component for a light emitting device comprising: a light diffusing layer comprising particles of a light scattering material, wherein the light diffusing layer has a shape with an inner surface that defines an interior volume; a wavelength conversion layer comprising particles of at least one photoluminescence material within the interior volume. The component advantageously comprises a dome shape or an elongated dome shape.

In some embodiments the wavelength conversion layer substantially fills the interior volume of the shape of the light diffusing layer. Alternatively, the wavelength conversion layer comprises the same shape as the light diffusing layer.

As with other embodiments of the invention the wavelength conversion layer comprises a mixture of the at least one phosphor material and a light transmissive binder and the light diffusing layer comprises a mixture of the light scattering material and the same light transmissive binder.

To reduce usage of the photoluminescence material the wavelength conversion layer can further comprise a second light scattering material. The light scattering material and the second light scattering material can have different material properties. Alternatively the two materials can comprise the same material.

The light transmissive binder can comprise a curable liquid polymer such as a polymer resin, a monomer resin, an acrylic, an epoxy, a silicone or a fluorinated polymer.

The weight loading of light scattering material to binder is in a range 7% to 35% and preferably in a range 10% to 20%.

There is disclosed that light scattering material(s) may have an average particle size in a range $1\mu m$ to $50\mu m$ and advantageously in a range $10\mu m$ to $20\mu m$.

The light diffusing layer can be formed using a molding process such as vacuum molding or an injection molding process. The wavelength conversion layer can be formed onto the diffusing layer using a molding process or formed by depositing phosphor material with a binder material into the interior volume of the light diffusing layer.

The light scattering material preferably comprises titanium dioxide, barium sulfate, magnesium oxide, silicon dioxide or aluminum oxide. Preferably the light scattering material has an average particle size that is selected such that the light scattering material will scatter excitation light relatively more than the light scattering material will scatter light generated by the at least one photoluminescence material. In a preferred embodiment the light scattering material scatters the excitation light at least twice as much as light generated by the at least one photoluminescence material. Where the excitation light comprises blue light, the light scattering material preferably has an average particle size that is less than about 150nm.

According to other embodiments of the invention a light emitting device, comprises: at least one solid-state light emitter operable to generate excitation light; a light diffusing layer comprising particles of a light scattering material, wherein the light diffusing layer has a shape with an inner surface that defines an interior volume; a wavelength conversion layer comprising particles of at least one photoluminescence material within the interior volume that is excitable by the excitation light.

Advantageously the light scattering material within the light diffusing layer corresponds to an average particle size that improves an OFF state white appearance of the light emitting device.

Further details of aspects, objects, and advantages of the invention are described below in the detailed description, drawings, and claims. Both the foregoing general description and the following detailed description are exemplary and explanatory, and are not intended to be limiting as to the scope of the invention.

BRIEF DESCRIPTION OF THE DRAWINGS

In order that the present invention is better understood LED-based light emitting devices and phosphor wavelength conversion components in accordance with the invention will now be described, by way of example only, with reference to the accompanying drawings in which like reference numerals are used to denote like parts, and in which:

FIG. 1 shows schematic partial cutaway plan and sectional views of a solid-state light emitting device in accordance with an embodiment of the invention;
FIG. 2 is a schematic of a phosphor wavelength conversion component in accordance with an embodiment of the invention;
FIG. 3 is a schematic of a phosphor wavelength conversion component in accordance with another embodiment of the invention;
FIG. 4 shows plots of emission color change versus emission angle for the device of FIG. 1 for phosphor wavelength conversion components containing 0%, 7%, 12%, 16%, 23% and 35% weight loadings of light diffractive material;
FIG. 5 is a plot of luminous efficacy (normalized) versus emission color change at an emission angle $\theta$=60° for the device of FIG. 1;
FIG. 6 shows plots of emission color change versus emission angle for a warm white ($\approx$3000K) solid-state light emitting device in accordance with the invention for wavelength conversion components containing different 0%, 10%, 15% and 20% weight loadings of light diffractive material;
FIG. 7 is a plot of luminous efficacy (normalized) versus emission color change at an emission angle $\theta$=60° for the warm white light emitting device for wavelength conversion components containing different 0%, 10%, 15% and 20% weight loadings of light diffractive material;
FIG. 8 is a 1931 C.I.E. (Commission Internationale de l'Eclairage) chromaticity diagram showing emission color at emission angles $\theta$=0°, 15°, 30°, 45° and 60° for the warm white light emitting device for wavelength conversion components containing 0%, 10%, 15% and 20% weight loadings of light diffractive material;
FIG. 9 shows schematic partial cutaway plan and sectional views of a high CRI solid-state light emitting device in accordance with another embodiment of the invention;
FIG. 10 shows plots of relative light scattering versus light diffractive particle size (nm) for red, green and blue light.
FIG. 11 is a schematic illustrating the principle of operation of a known light emitting device;
FIG. 12 is a schematic illustrating the principle of operation of the light emitting device having scattering particles mixed with phosphor particles in accordance with an embodiment of the invention;
FIG. 13 is a plot of emission intensity versus chromaticity CIE x for an LED-based light emitting device in accordance with the invention for different weight percent loadings of light reflective material;
FIG. 14 is a schematic illustrating a light emitting device having scattering particles within both a wavelength conversion layer and a diffusing layer according to an embodiment of the invention;
FIGs. 15 and 16 illustrate, respectively, a perspective view and a cross-sectional view of an application of a wavelength conversion component in accordance with some embodiments;
FIG. 17 is a schematic illustrating a light emitting device having a diffusing layer formed as a dome-shaped shell, in which a wavelength conversion layer forms an inner layer on an interior surface of the dome-shaped diffusing layer, according to an embodiment of the invention;
FIG. 18 is a schematic illustrating a light emitting device having a diffusing layer formed as a dome-shaped shell, in which a wavelength conversion layer substantially fills an interior volume formed by the interior surface of the dome-shaped diffusing layer;
FIG. 19 is a schematic illustrating a light emitting device having a diffusing layer formed as a dome-shaped shell, in which a wavelength conversion layer having scattering particles substantially fills an interior volume formed by the interior surface of the dome-shaped diffusing layer;

FIGs. **20A, 20B,** and **20C** illustrate an example of an application of a wavelength conversion component in accordance with some embodiments;

FIGs. **21A, 21B,** and **21C** illustrate another example of an application of a wavelength conversion component in accordance with some embodiments;

FIG **22** illustrates another example of an application of a wavelength conversion component in accordance with some embodiments;

FIGs. **23A** and **23B** illustrate another example of an application of a wavelength conversion component in accordance with some embodiments; and

FIG. **24** illustrates a perspective of another application of a wavelength conversion component in accordance with some embodiments.

DETAILED DESCRIPTION OF THE INVENTION

Some embodiments of the invention are directed to light emitting devices comprising one or more solid-state light emitters, typically LEDs, that is/are operable to generate excitation light (typically blue or UV) which is used to excite a wavelength conversion component containing particles of a photoluminescence materials (e.g. phosphor materials), such as a blue light excitable phosphor material or an UV excitable phosphor material. Additionally the wavelength conversion component comprises a light diffusing layer comprising particles of a light diffractive material (also referred to herein as "light scattering material"). One benefit of this arrangement is that by selecting an appropriate particle size and concentration per unit area of the light diffractive material, it is possible to make a device having an emission product color that is virtually uniform with emission angle over a $\pm 60°$ range from the emission axis. Moreover the use of a light diffusing layer can substantially reduce the quantity of phosphor material required to generate a selected color of emitted light. In addition, the light diffusing layer can significantly improve the white appearance of the light emitting device in its OFF state.

For the purposes of illustration only, the following description is made with reference to photoluminescence material embodied specifically as phosphor materials. However, the invention is applicable to any type of any type of photoluminescence material, such as either phosphor materials or quantum dots. A quantum dot is a portion of matter (e.g. semiconductor) whose excitons are confined in all three spatial dimensions that may be excited by radiation energy to emit light of a particular wavelength or range of wavelengths. In addition, the following description is made with reference to radiation sources embodied specifically as blue light sources. However, the invention is applicable any type of radiation source, including blue light sources and UV light sources.

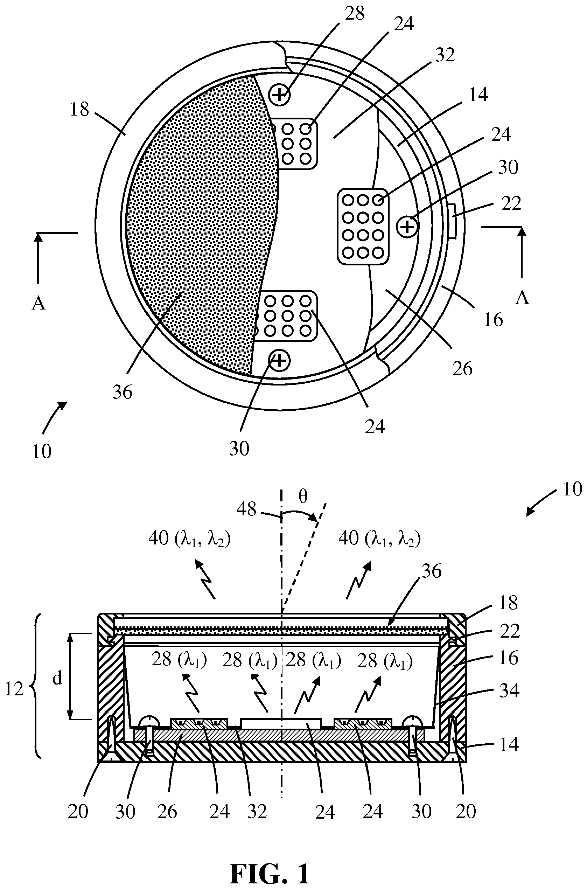

A solid-state light emitting device **10** in accordance with an embodiment of the invention will now be described with reference to FIG. **1** which shows schematic partial cutaway plan and sectional views of the device. The device **10** is configured to generate warm white light with a CCT (Correlated Color Temperature) of approximately 3000K and a luminous flux of approximately 1000 lumens.

The device **10** comprises a hollow cylindrical body **12** composed of a circular disc-shaped base **14**, a hollow cylindrical wall portion **16** and a detachable annular top **18**. To aid in the dissipation of heat the base **14** is preferably fabricated from aluminum, an alloy of aluminum or any material with a high thermal conductivity (preferably $\geq 200 \mathrm{Wm^{-1}K^{-1}}$) such as for example copper, a magnesium alloy or a metal loaded plastics material. For low cost production the wall **16** and top **18** are preferably fabricated from a thermoplastics material such as HDPP (High Density Polypropylene), nylon or PMA (polymethyl acrylate). Alternatively they can be fabricated from a thermally conductive material such as aluminum or an aluminum alloy. As indicated in FIG. **1** the base **14** can be attached to the wall portion **16** by screws or bolts **20** or by other fasteners or by means of an adhesive. As further shown in FIG. **1** the top **18** can be detachably mounted to the wall portion **16** using a bayonet-type mount in which radially extending tabs **22** engage in a corresponding annular groove in the top **18**.

The device **10** further comprises a plurality (four in the example illustrated) of blue light emitting LEDs **24** (blue LEDs) that are mounted in thermal communication with a circular-shaped MCPCB (metal core printed circuit board) **26**. The blue LEDs **24** can comprise 4.8W Cetus™ C1109 chip on ceramic devices from Intematix Corporation of Fremont, California in which each device comprises a ceramic packaged array of twelve 0.4W GaN-based (gallium nitride-based) blue LED chips that are configured as a rectangular array 3 rows by 4 columns. Each blue LED **24** is operable to generate blue light **28** having a peak wavelength $\lambda_1$ in a wavelength range 400nm to 480nm (typically 450nm to 470nm). As is known an MCPCB comprises a layered structure composed of a metal core base, typically aluminum, a thermally conductive/electrically insulating dielectric layer and a copper circuit layer for electrically connecting electrical components in a desired circuit configuration. The metal core base of the MCPCB **26** is mounted in thermal communication with the base **14** with the aid of a thermally conductive compound such as for example an adhesive containing a standard heat sink compound containing beryllium oxide or aluminum nitride. As shown in FIG. **1** the MCPCB can be attached to the base using screws or bolts **30**.

To maximize the emission of light, the device **10** can further comprise light reflective surfaces **32**, **34** that respectively cover the face of the MCPCB **26** and the inner curved surface of the top **18.** Typically the light reflective surfaces **32**, **34** can comprise a highly light reflective sheet material such as WhiteOptics™ "White 97" (A high-density polyethylene fiberbased composite film) from A.L.P. lighting Components, Inc of Niles, Illinois, USA. As indicated in FIG. **1** a circular disc **32** of the material can used to cover the face of the MCPCB and a strip of the light reflective material configured as a cylindrical sleeve **34** that is inserted in the housing and is configured to cover the inner surface of the housing wall portion **16.**

The device **10** further comprises a phosphor wavelength conversion component **36** that is operable to absorb a proportion of the blue light **28** ($\lambda_1$) generated by the LEDs **24** and convert it to light **38** of a different wavelength ($\lambda_2$) by a process of photoluminescence **36.** The emission product **40** of the device **10** comprises the combined light of wavelengths $\lambda_1$, $\lambda_2$ generated by the LEDs **24** and the phosphor wavelength conversion component **36.** The wavelength conversion component is positioned remotely to the LEDs **24** and is spatially separated from the LEDs a distance **d** that is typically at least 1cm. In this patent specification "remotely" and "remote" means in a spaced or separated relationship. The wavelength conversion component **36** is configured to completely cover the housing **12** opening such that all light emitted by the lamp passes through the component **36.** As shown the wavelength conversion component **36** can be detachably mounted to the top of the wall portion **16** using the top **18** enabling the component and emission color of the lamp to be readily changed.

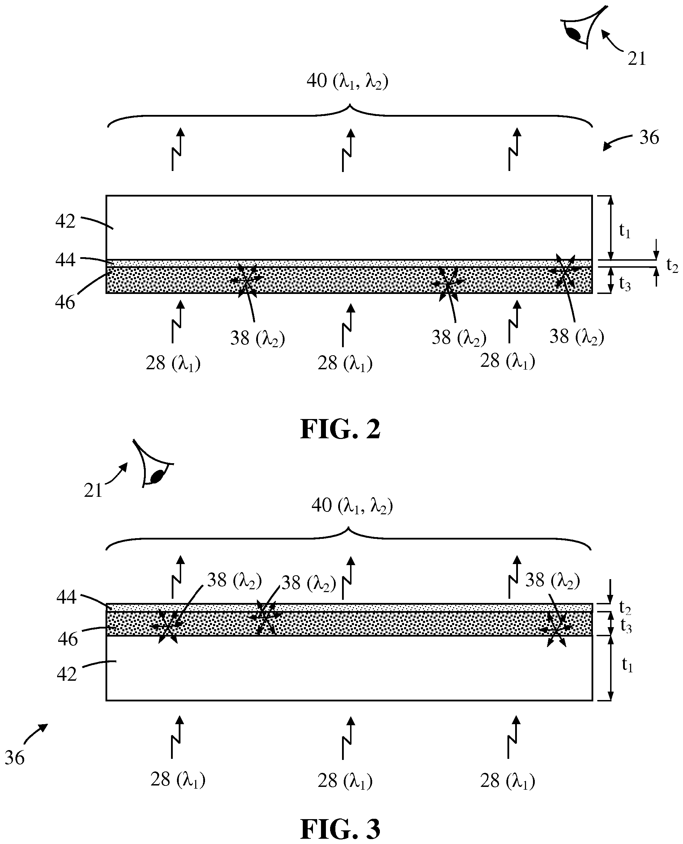

As shown in FIG. **2,** the wavelength conversion component **36** comprises, in order, a light transmissive substrate **42,** a light diffusing layer **44** containing light diffractive particles and a wavelength conversion layer **46** containing one or more photoluminescent (e.g. phosphor) materials. As can be seen in FIG. **2** the wavelength conversion component **36** is configured such that in operation the wavelength conversion layer **46** faces the LEDs.

The light transmissive substrate **42** can be any material that is substantially transmissive to light in a wavelength range 380nm to 740nm and can comprise a light transmissive polymer such as a polycarbonate or acrylic or a glass such as a borosilicate glass. For the lamp **10** of FIG. **1** the substrate **42** comprises a planar circular disc of diameter $\varphi$= 62mm and thickness **$t_1$** which is typically 0.5mm to 3mm. In other embodiments the substrate can comprise other geometries such as being convex or concave in form such as for example being dome shaped or cylindrical.

The diffusing layer **44** comprises a uniform thickness layer of particles of a light diffractive material, preferably titanium dioxide ($TiO_2$). In alternative arrangements the light diffractive material can comprise barium sulfate ($BaSO_4$), magnesium oxide (MgO), silicon dioxide ($SiO_2$), aluminum oxide ($Al_2O_3$) or a powdered material with as high a reflectivity as possible, typically a reflectance of 0.9 or higher. The light diffractive material powder is thoroughly mixed in known proportions with a light transmissive liquid binder material to form a suspension and the resulting mixture deposited onto the face of the substrate **42** preferably by screen printing to form a uniform layer of thickness **$t_2$** (typically in a range 10$\mu$m to 75$\mu$m) that covers the entire face of the substrate. The quantity of light diffracting material per unit area in the light diffusing layer **44** will typically in a range 10$\mu$g.cm$^{-2}$ to 5mg.cm$^{-2}$.

Whilst screen printing is a preferred method for depositing the light diffractive diffusing layer **44,** it can be deposited using other techniques such as for example slot die coating, spin coating, roller coating, drawdown coating or doctor blading. The binder material can comprise a curable liquid polymer such as a polymer resin, a monomer resin, an acrylic, an epoxy (polyepoxide), a silicone or a fluorinated polymer. It is important that the binder material is, in its cured state, substantially transmissive to all wavelengths of light generated by the phosphor material(s) and the LEDs **24** and preferably has a transmittance of at least 0.9 over the visible spectrum (380nm to 800nm). The binder material is preferably U.V. curable though it can be thermally curable, solvent based or a combination thereof. U.V. or thermally curable binders can be preferable because, unlike solvent-based materials, they do not "outgas" during polymerization. In one arrangement the average particle size of the light diffractive material is in a range 5$\mu$m to 15$\mu$m though as will be described it can be in a nanometer range (nm) and is advantageously in a range 100nm to 150nm. The weight percent loading of light diffractive material to liquid binder is typically in a range 7% to 35%.

The wavelength conversion layer **46** is deposited in direct contact with the light diffusing layer **44** without any intervening layers or air gaps. The phosphor material, which is in powder form, is thoroughly mixed in known proportions with a liquid light transmissive binder material to form a suspension and the resulting phosphor composition, "phosphor ink", deposited directly onto the diffusing layer **44.** The wavelength conversion layer is preferably deposited by screen printing though other deposition techniques such as slot die coating, spin coating or doctor blading can be used. To eliminate an optical interface between the wavelength conversion and diffusing layers **46, 44** and to maximize the transmission of light between layers, the same liquid binder material is preferably used to fabricate both layers; that is, a polymer resin, a monomer resin, an acrylic, an epoxy, a silicone or a fluorinated polymer.

The phosphor wavelength conversion layer **46** is preferably deposited by screen printing though other deposition techniques such as for example slot die coating, spin coating, roller coating, drawdown coating or doctor blading can be used. The binder material is preferably U.V. or thermally curable rather than being solvent-based. When a solvent evaporates the volume and viscosity of the composition will change and this can result in a higher concentration of phosphor material which will affect the emission product color of the device. With U.V. curable polymers, the viscosity and solids ratios are more stable during the deposition process with U.V. curing being used to polymerize and solidify the layer after deposition is completed. Moreover since in the case of screen printing of the phosphor ink multiple-pass printing may be required to achieve a required layer thickness, the use of a U.V. curable binder is preferred since each layer can be cured virtually immediately after printing prior to printing of the next layer.

The color of the emission product produced by the wavelength conversion component depends on the phosphor material composition and the quantity of phosphor material per unit area in the wavelength conversion layer **46.** It will be appreciated that the quantity of phosphor material per unit area is dependent on the thickness $t_3$ of the wavelength conversion layer **46** and the weight loading of phosphor material to binder in the phosphor ink. In applications in which the emission product is white or in applications in which the emission product has a high saturation color (i.e. the emission product comprises substantially all photoluminescence generated light) the quantity of phosphor material per unit area in the wavelength conversion layer **46** will typically be between 10mg.cm$^{-2}$ and 40mg.cm$^{-2}$. To enable printing of the wavelength conversion layer **46** in a minimum number of print passes the phosphor ink preferably has as high a solids loading of phosphor material to binder material as possible and preferably has a weight loading of phosphor material to binder in a range 40% to 75%. For weight loadings below about 40% it is found that five or more print passes may be necessary to achieve a required phosphor material per unit area. The phosphor material comprises particles with an average particle size of $10\mu m$ to $20\mu m$ and typically of order $15\mu m$.

In general lighting applications the emission product **40** will typically be white light and the phosphor material can comprise one or more blue light excitable phosphor materials that emit green (510nm to 550 nm), yellow-green (550nm to 570nm), yellow (570nm to 590nm), orange (590nm to 630nm) or red (630nm to 740nm) light. The thickness $t_3$ of the wavelength conversion layer, phosphor material composition and the density (weight loading) of phosphor material per unit area will determine the color of light emitted by the lamp.

The phosphor material can comprise an inorganic or organic phosphor such as for example silicate-based phosphor of a general composition $A_3Si(O,D)_5$ or $A_2Si(O,D)_4$ in which Si is silicon, O is oxygen, A comprises strontium (Sr), barium (Ba), magnesium (Mg) or calcium (Ca) and D comprises chlorine (Cl), fluorine (F), nitrogen (N) or sulfur (S). Examples of silicate-based phosphors are disclosed in United States patents US 7,575,697 B2 *"Silicate-based green phosphors"*, US 7,601,276 B2 *"Two phase silicate-based yellow phosphors"*, US 7,655,156 B2 *"Silicate-based orange phosphors"* and US 7,311,858 B2 *"Silicate-based yellow-green phosphors"*. The phosphor can also comprise an aluminate-based material such as is taught in co-pending patent application US2006/0158090 A1 *"Novel aluminate-based green phosphors"* and patent US 7,390,437 B2 *"Aluminate-based blue phosphors",* an aluminum-silicate phosphor as taught in co-pending application US2008/0111472 A1 *"Aluminum-silicate orange-red phosphor"* or a nitride-based red phosphor material such as is taught in co-pending United States patent application US2009/0283721 A1 *"Nitride-based red phosphors"* and International patent application WO2010/074963 A1 *"Nitride-based red-emitting in RGB (red-green-blue) lighting systems"*. It will be appreciated that the phosphor material is not limited to the examples described and can comprise any phosphor material including nitride and/or sulfate phosphor materials, oxy-nitrides and oxy-sulfate phosphors or garnet materials (YAG).

A further example of a phosphor wavelength conversion component **36** in accordance with the invention is illustrated in FIG. **3.** In common with the wavelength conversion component of FIG. **2** the component comprises a light transmissive substrate **42,** a light diffusing layer **44** and a wavelength conversion layer **46.** In accordance with the invention the light diffusing and wavelength conversion layers **44, 46** are deposited in direct contact with one another. Again in operation the component is configured such that the wavelength conversion component is configured such that the light diffusing layer **44** faces the LEDs **24.**

In operation blue light **28** generated by the LEDs **24** travels through the wavelength conversion layer **46** until it strikes a particle of phosphor material. It is believed that on average as little as 1 in 1000 interactions of a photon with a phosphor material particle results in absorption and generation of photo luminescence light **38.** The majority, about 99.9%, of interactions of photons with a phosphor particle result in scattering of the photon. Due to the isotropic nature of the scattering process on average half of the photons will scattered in a direction back towards the LEDs. Tests indicate that typically about 10% of the total incident blue light **28** is scattered and emitted from the wavelength conversion component **36** in a direction back towards the LEDs. For a cool white light emitting device the amount of phosphor material is selected to allow approximately 10% of the total incident blue light to be emitted from the wavelength conversion component and contribute to the emission product **40** that is viewed by an observer **21.** The majority, approximately 80%, of the incident light is absorbed by the phosphor material and re-emitted as photo luminescence light **38.** Due to the isotropic nature of photo luminescence light generation, approximately half of the light **38** generated by the phosphor material will be emitted in a direction towards the LED. As a result only up to about 40% of the total incident light will be emitted as light **38** of wavelength $\lambda_2$ and contributes to the emission product **38** with the remaining (up to about 40%) of the total incident light being emitted as light **38** of wavelength $\lambda_2$ in a direction back towards the LED. Light emitted towards the LEDs from the wavelength conversion component **36** is re-directed by the light diffractive surfaces **32, 34** to contribute to the emission product and to increase the overall efficiency of the device.

One problem associated with a conventional LED lighting device that is addressed by embodiments of the invention is the non-white color appearance of the device in an OFF state. As discussed, during an ON state, the LED chip or die generates blue light and some portion of the blue light is thereafter absorbed by the phosphor(s) to re-emit yellow light (or a combination of green and red light, green and yellow light, green and orange or yellow and red light). The portion of the blue light generated by the LED that is not absorbed by the phosphor combined with the light emitted by the phosphor provides light which appears to the human eye as being nearly white in color.

However, in an OFF state, the LED chip or die does not generate any blue light. Instead, light that is produced by the remote phosphor lighting apparatus is based at least in part upon external light (e.g. sunlight or room lights) that excites the phosphor material in the wavelength conversion component, and which therefore generates a yellowish, yellow-orange or orange color in the photoluminescence light. Since the LED chip or die is not generating any blue light, this means that there will not be any residual blue light to combine with the yellow/orange light from the photoluminescence light of the wavelength conversion component to generate white appearing light. As a result, the lighting device will appear to be yellowish, yellow-orange or orange in color. This may be undesirable to the potential purchaser or customer that is seeking a white-appearing light.

According to some embodiments, the light diffusing layer **44** provides the additional benefit of addressing this problem by improving the visual appearance of the device in an OFF state to an observer **21**. In part, this is because the light diffusing layer **44** includes particles of a light diffractive material that can substantially reduce the passage of external excitation light that would otherwise cause the wavelength conversion component to re-emit light of a wavelength having a yellowish/orange color.

The particles of a light diffractive material in the light diffusing layer **44** are selected, for example, to have a size range that increases its probability of scattering blue light, which means that less of the external blue light passes through the light diffusing layer **44** to excite the wavelength conversion layer **46.** Therefore, the remote phosphor lighting apparatus will have more of a white appearance in an OFF state since the wavelength conversion component is emitting less yellow/red light.

The light diffractive particle size can be selected such that the particles will scatter blue light relatively at least twice as much as they will scatter light generated by the phosphor material. Such a light diffusing layer **44** ensures that during an OFF state, a higher proportion of the external blue light received by the device will be scattered and directed by the light diffractive material away from the wavelength conversion layer **46,** decreasing the probability of externally originated photons interacting with a phosphor material particle and minimizing the generation of the yellowish/orange photoluminescence light. However, during an ON state, phosphor generated light caused by excitation light from the LED light source can nevertheless pass through the diffusing layer **44** with a lower probability of being scattered. Preferably, to enhance the white appearance of the lighting device in an OFF state, the light diffractive material within the light diffusing layer **44** is a "nano-particle" having an average particle size of less than about 150nm. For light sources that emit lights having other colors, the nano-particle may correspond to other average sizes. For example, the light diffractive material within the light diffusing layer **44** for an UV light source may have an average particle size of less than about 100nm.

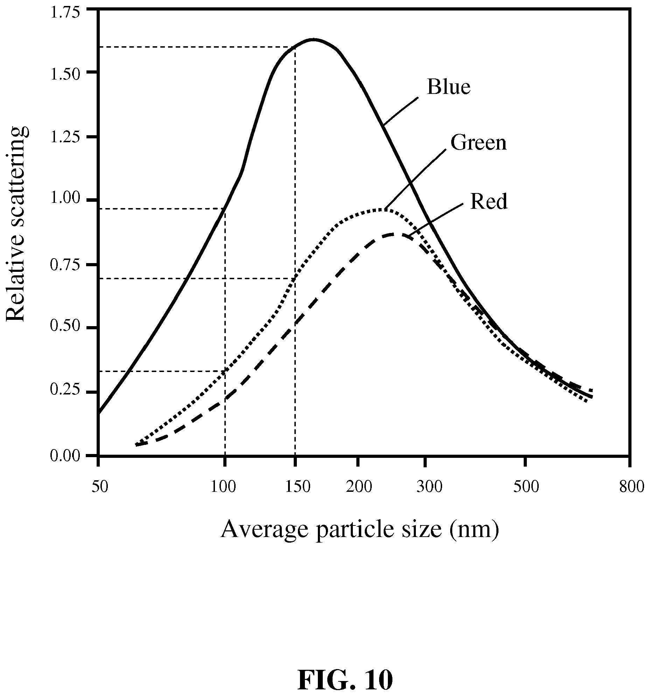

Therefore, by appropriate selection of the average particle size of the light scattering material, it is possible to configure the light diffusing layer such that it scatters excitation light (e.g. blue light) more readily than other colors, namely green and red as emitted by the photoluminescence materials. FIG. **10** shows plots of relative light scattering versus $TiO_2$ average particle size (nm) for red, green and blue light. As can be seen from FIG. **10,** $TiO_2$ particles with an average particle size of 100nm to 150nm are more than twice as likely to scatter blue light (450nm to 480nm) than they will scatter green light (510nm to 550nm) or red light (630nm to 740nm). For example $TiO_2$ particles with an average particle size of 100nm will scatter blue light nearly three times (2.9=0.97/0.33) more than it will scatter green or red light. For $TiO_2$ particles with an average particle size of 200nm these will scatter blue light over twice (2.3=1.6/0.7) as much as they will scatter green or red light. In accordance with some embodiments of the invention, the light diffractive particle size is preferably selected such that the particles will scatter blue light relatively at least twice as much as light generated by the phosphor material(s).

Another problem with remote phosphor devices that can be addressed by embodiments of the invention is the variation in color of emitted light with emission angle. In particular, remote phosphor devices are often subject to perceptible non-uniformity in color when viewed from different angles.

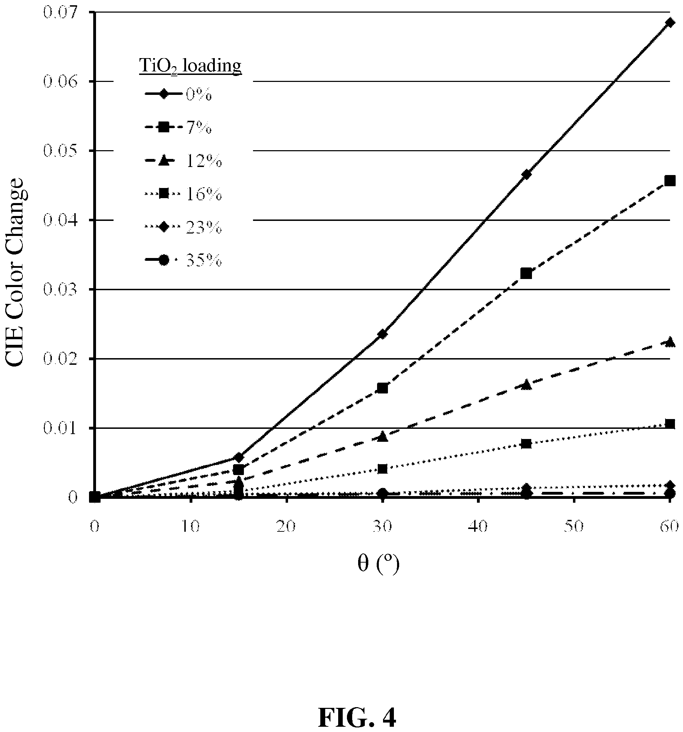

Embodiments of the invention correct for this problem, since the addition of a light diffusing layer **44** in direct contact with the wavelength conversion layer **46** significantly increases the uniformity of color of emitted light with emission angle θ. The emission angle θ is measured with respect to an emission axis **48** (FIG. **1**). FIG. **4** shows plots of measured CIE color change versus emission angle θ for the lamp of FIG. **1** for wavelength conversion components **36** comprising diffusing layer **44** with percentage (%) weight loadings of light diffractive material to binder material of 0%, 7%, 12%, 16%, 23% and 35%, according to some example implementations of the invention. All emission color measurements were measured at a distance of 10m from the lamp **10** for wavelength conversion components in which the light diffusing layer comprises light diffractive particles of $TiO_2$ with an average particle size ≈5μm. For comparison the data for a 0% percentage loading of $TiO_2$ correspond to a wavelength conversion component that does not include a light diffusing layer.

The measured color change is derived from the relationship:

$$\text{CIE change} = \sqrt{(\text{CIE } x_{\theta°} - \text{CIE } x_{0°})^2 + (\text{CIE } y_{\theta°} - \text{CIE } y_{0°})^2}$$

where CIE $x_{\theta°}$ is the measured CIE chromaticity x value at an emission angle of $\theta°$, CIE $x_{0°}$ is the measured CIE chromaticity x value for an emission angle of $\theta=0°$, CIE $y_{\theta°}$ is the measured CIE chromaticity y value at an emission angle of $\theta°$ and CIE $y_{0°}$ is the measured CIE chromaticity y value at an emission angle of $\theta=0°$. It will be appreciated that the CIE change is normalized to the light color at an emission angle $\theta=0°$ (i.e. the CIE change is always 0 for $\theta=0°$).

As can be seen in FIG. **4** for a wavelength conversion component with no light diffusing layer (i.e. 0% Ti0$_2$ loading), the color of light generated by such a lamp can alter by a CIE change of nearly 0.07 for emission angles up to $\theta=60°$. In comparison for a wavelength conversion component **36** in accordance with the invention that includes a light diffusing layer **44** with a percentage weight loading of TiO$_2$ of only 7% the change in emission color over a 60° range drops to about 0.045. As can be seen from this figure, increasing the percentage weight loading of TiO$_2$ decreases the change in emission color over a 60° angular range. For example for a 35% TiO$_2$ percentage weight loading the CIE color change is less than 0.001. Although the change in emission color with emission angle decreases with increasing TiO$_2$ loading the total emission intensity will also decrease.

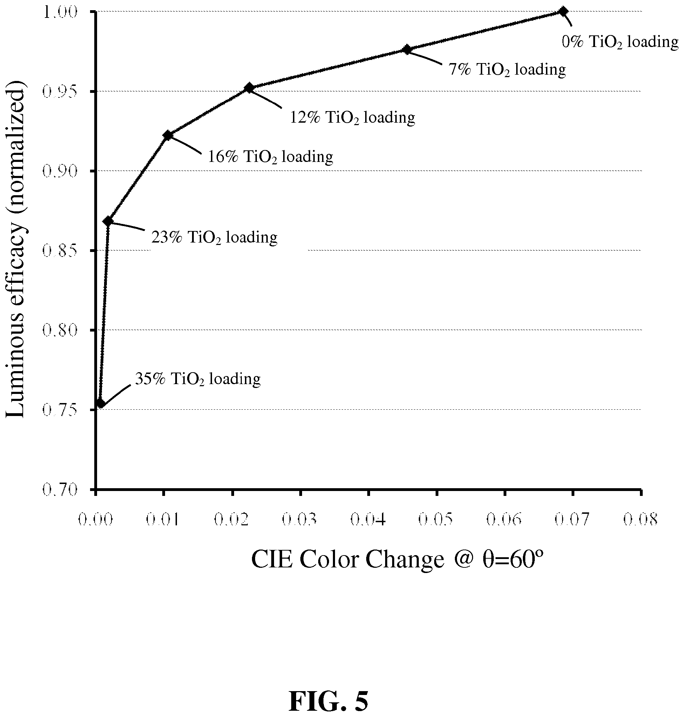

FIG. **5** shows measured luminous efficacy versus CIE color change at an emission angle $\theta=60°$ for wavelength conversion components **36** comprising diffusing layer **44** with percentage (%) weight loadings of TiO$_2$ to binder material of 0%, 7%, 12%, 16%, 23% and 35% for an example implementation of the invention. The luminous efficacy values are normalized relative to a lamp that does not include a light diffusing layer (i.e. 0% TiO$_2$ loading). The CIE color change @ $\theta=60°$ is determined from the relationship:

$$\sqrt{(\text{CIE } x_{60°} - \text{CIE } x_{0°})^2 + (\text{CIE } y_{60°} - \text{CIE } y_{0°})^2}$$

where CIE $x_{60°}$ is the measured CIE chromaticity x value at an emission angle of 60°, CIE $x_{0°}$ is the measured CIE chromaticity x value for an emission angle of 0°, CIE $y_{60°}$ is the measured CIE chromaticity y value at an emission angle of 60° and CIE $y_{0°}$ is the measured CIE chromaticity y value at an emission angle of 0°. As can be seen from FIG. **5,** there can be as much as a 25% decrease in luminous efficacy for a wavelength conversion component with a light diffusing layer containing a 35% weight loading of TiO$_2$. It will be appreciated when selecting the weight loading of light diffractive material in light diffusing layer a balance should be struck between improving emission color uniformity with emission angle and the decrease in luminous efficacy of the lamp. Wavelength conversion component in accordance with some embodiments of the invention preferably has a light diffusing layer with percentage weight loading of light diffractive material to binder material in a range 10% to 20%.

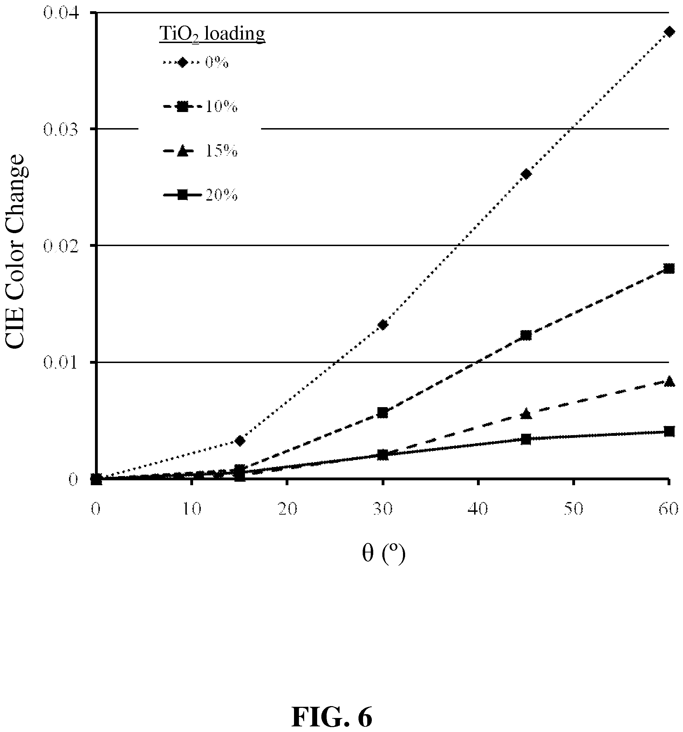

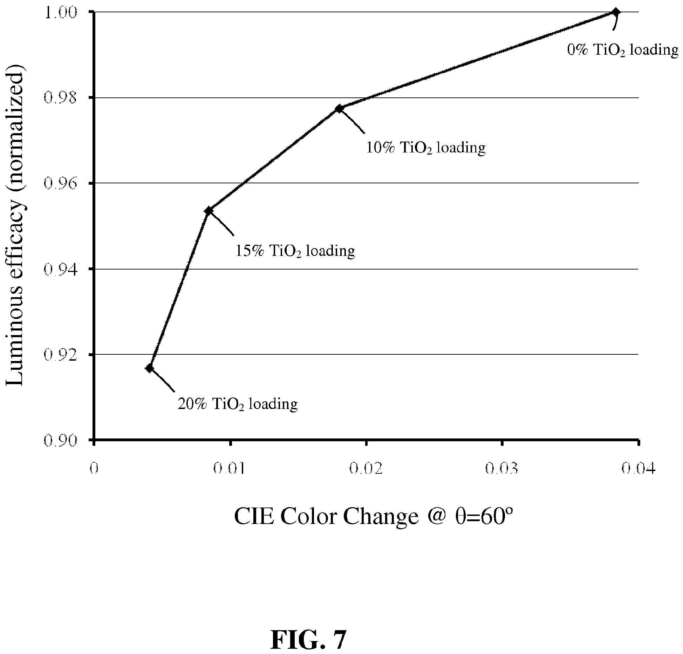

FIG. **6** shows plots of measured CIE color change versus emission angle $\theta$ for an example implementation of a 3000K white light emitting lamp **10** for conversion components **36** comprising diffusing layer **44** with percentage (%) weight loadings of TiO$_2$ to binder material of 0%, 10%, 15% and 20% whilst FIG. **7** shows corresponding measured luminous efficacy versus CIE color change at an emission angle $\theta=60°$.

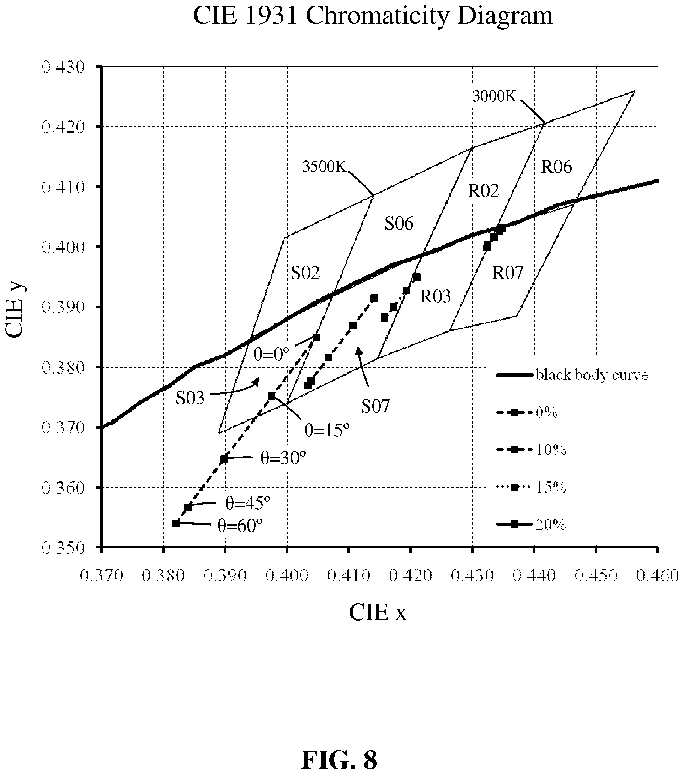

FIG. **8** is a 1931 chromaticity diagram showing the color CIE x, CIE y) of emitted light at emission angles $\theta=0°$, 15°, 30°, 45° and 60° for a an example 3000K white light emitting LED-based lamp in accordance with the invention for wavelength conversion components containing 0%, 10%, 15% and 20% weight loadings of TiO$_2$. For comparison FIG. **8** also includes the black body radiation curve and ANSI C78.377A *"Specification for chromaticity of white solid state lighting products"* S and R quadrangles for white light of 3500K and 3000K respectively. Each quadrangle is equivalent to approximately seven MacAdam ellipses whilst each sub quadrangle (S02, S03, S06, S07, R02, R03, R06, R07) is equivalent to approximately four McAdam ellipses. As is known a MacAdam ellipse is a region on a chromaticity diagram which contains all colors which are indistinguishable, to the average human eye **21**, from the color at the center of the ellipse. As can be seen from FIG. **8** for a lamp without a light diffusing layer (0% TiO$_2$), the variation in emission color for emission angles of over a range $\theta=0°$ to 60° is approximately three MacAdam ellipses. For a lamp including a light diffusing layer with a 10% weight loading of TiO$_2$, the variation in emission color with emission angle is less than two MacAdam ellipses with a corresponding decrease in luminous efficacy of about 2% (FIG. **7**). For a lamp including a light diffusing layer with a 15% weight loading of TiO$_2$, the variation in emission color with emission angle is approximately one MacAdam ellipse with a corresponding decrease in luminous efficacy of about 5% (FIG. **7**). For such a lamp, an average person **21** would be unable to perceive the variation in emission color with emission angle. For a lamp including a light diffusing layer with a 20% weight loading of TiO$_2$ the variation in emission color with emission angle is less than one MacAdam ellipse with a corresponding decrease in luminous efficacy of about 9% (FIG. **7**). It will be appreciated the inclusion of a light diffusing layer **44** in accordance with the invention can virtually eliminate the effects of emission color variation with emission angle whilst maintaining an acceptable luminous efficacy.

Embodiments of the present invention can also be used to reduce the amount of phosphor materials that is required to manufacture an LED lighting product, thereby reducing the cost of manufacturing such products given the relatively costly nature of the phosphor materials. In particular, the addition of a light diffusing layer **44** composed of particles of a light diffractive material can substantially reduce the quantity of phosphor material required to generate a selected color of emitted light. This means that relatively less phosphor is required to manufacture a wavelength conversion component as compared to comparable prior art approaches. As a result, it will be much less costly to manufacture lighting apparatuses that employ such wavelength conversion components, particularly for remote phosphor lighting devices.

In operation, the diffusing layer **44** increases the probability that a photon will result in the generation of photoluminescence light by reflecting light back into the wavelength conversion layer **46.** Therefore, inclusion of a diffusing layer with the wavelength conversion layer can reduce the quantity of phosphor material required to generate a given color emission product, e.g. by up to 40%.

As previously noted, the light diffusing layer **44** can be configured such that it selectively scatters excitation light generated by the LEDs (e.g. blue light) more than it scatters light generated by the phosphor material. Such a light diffusing layer **44** ensures that a higher proportion of the blue light emitted from the wavelength conversion layer will be scattered and directed by the light diffractive material back into the wavelength conversion layer increasing the probability of the photon interacting with a phosphor material particle and resulting in the generation of photoluminescence light. At the same time phosphor generated light can pass through the diffusing layer with a lower probability of being scattered. Since the diffusing layer increases the probability of blue photons interacting with a phosphor material particle less phosphor material can be used to generate a selected emission color. Such an arrangement can also increase luminous efficacy of the wavelength conversion component/device.

The light diffusing layer **44** can be used in combination with additional scattering (or reflective/diffractive) particles in the wavelength conversion component to further reduce the amount of phosphor material that is required to generate a selected color of emitted light. As disclosed in U.S. Application Ser. No. 13/253,031, a wavelength conversion component comprises particles of a light scattering material (also referred to herein as "light reflecting material") that is incorporated with the phosphor material to enhance photoluminescence light generation by the phosphor material. The enhanced light generation results from the light reflective material increasing the number of collisions of light generated by the light emitter(s) with particles of the phosphor material. The net result is a decrease in phosphor material usage for the light emitting devices.

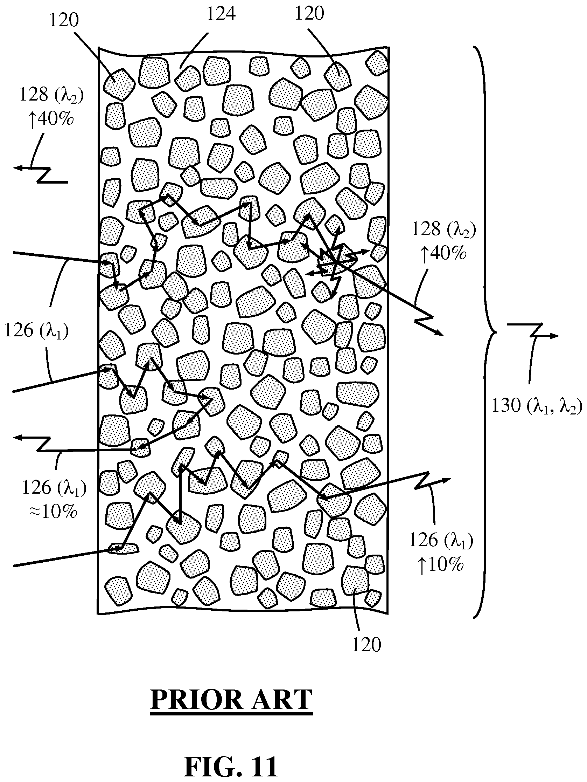

To explain this aspect of the current embodiment, it is helpful to first provide an explanation of the prior art approach that does not mix phosphors with scattering particles. FIG. **11** shows a schematic of an LED-based light emitting device that utilizes phosphor wavelength conversion without scattering particles mixed in with phosphors. The known device of FIG. **11** includes a wavelength conversion component that includes phosphor material particles **120** homogeneously distributed throughout the volume of a light transmissive binder **124**. Unlike the device of the invention, the known devices do not include particles of a light scattering material. In operation blue light **126** from the LED is transmitted by the light transmissive binder **124** until it strikes a particle of phosphor material. It is believed that on average as little as 1 in a 10,000 interactions of a photon with a phosphor material particle results in absorption and generation of photoluminescence light. The majority, about 99.99%, of interactions of photons with a phosphor particle result in scattering of the photon. Due to the isotropic nature of the scattering process on average half the scattered photons will be in a direction back towards the LED. Tests indicate that typically about 10% of the total incident blue light is scattered and emitted from the wavelength conversion component in a direction back towards the LED. For a cool white light emitting device the amount of phosphor material is selected to allow approximately 10% of the total incident blue light to be emitted through the window and contribute to the emission product. The majority, approximately 80%, of the incident light is absorbed by the phosphor material and re-emitted as photoluminescence light **128**. Due to the isotropic nature of photoluminescence light generation, approximately half of the light **128** generated by the phosphor material will be emitted in a direction towards the LED. As a result up to (↑) 40% of the total incident light will be emitted as light **128** of wavelength $\lambda_2$ and contributes to the emission product **130** whilst up to (t) 40% of the total incident light will be emitted as light **128** of wavelength $\lambda_2$ in a direction back towards the LED. Typically light that is emitted towards the LED is re-directed by a reflector (not shown) to increase the overall efficacy of the device.

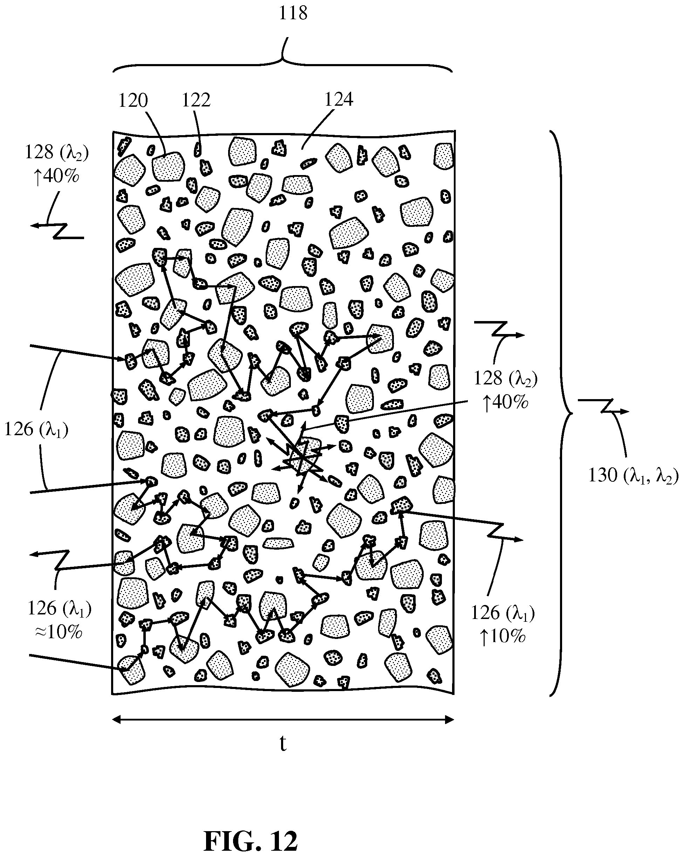

FIG. **12** shows a schematic of operation of a device that is similar to that of FIG. **11** but additionally includes reflection or scattering of light (of wavelengths $\lambda_1$ and $\lambda_2$) by the particles of the light reflective/scattering material. By including particles of a light reflective material with the phosphor material, this can reduce the amount of phosphor material required to generate a given color emission product, e.g. by up to 33% in some embodiments. The particles of light reflective material increase the probability of photons striking a particle of phosphor material and thus for an emission product of a given color less phosphor material is required.

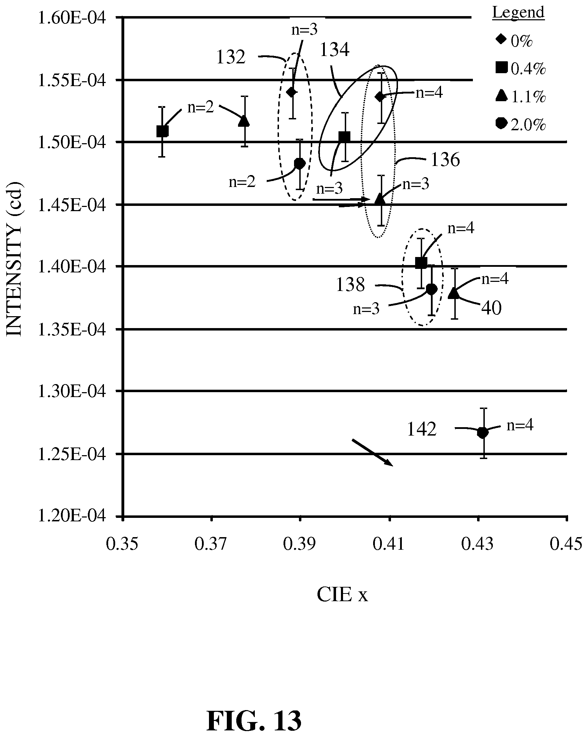

FIG. **13** is a plot of emission intensity versus chromaticity CIE x for a light emitting device in accordance with some embodiments of the invention for weight percent loadings of light reflective material of ♦- 0%, ■- 0.4%, ▲- 1.1% and ●- 2%. The data are for screen printed phosphor conversion layers in which the binder material comprises Nazdar's® UV curable litho clear overprint PSLC-294 and the phosphor material comprises Intematix Corporation's phosphor EY4453 with an average particle size of 15μm. The ratio of phosphor material to clear ink is in a proportion of 2:1 by weight. The light reflective material comprises Norcote International Inc's super white ink GN-027SA. The figures for loading of light reflective material refer to weight percent of super white ink to clear ink. The smaller reference numerals associated with each data point indicate the number 'n' of print passes used to form the phosphor layer.

The phosphor material and light scattering material, which can be in powder form, are thoroughly mixed in known proportions with the light transmissive binder material, such as a polymer material (for example a thermally or UV curable silicone or an epoxy material) or a clear ink such as for example Nazdar's® UV curable litho clear overprint PSLC-294. The mixture is applied to the face of a substrate as one or more layers of uniform thickness. In a preferred embodiment the mixture is applied to the light transmissive window by screen printing and the thickness $t$ of the layer controlled by the number of printing passes. The phosphor/reflective material mixture can be applied using other methods including inkjet printing, spin coating or sweeping the mixture over the surface using a blade such as a squeegee (e.g. doctor blading).

It will be appreciated that the number of print passes is directly proportional to the thickness of the phosphor layer **118** and quantity of phosphor. The ovals **132, 134, 136, 138** are used to group data points for emission products that have substantially the same intensity and CIE x values. For example oval **132** indicates that an emission product of similar intensity and color can be produced for a phosphor conversion layers **118** comprising i) 3 print passes without light reflective material and ii) 2 print passes with a 2% loading of light reflective material. These data indicate that by the inclusion of a 2% weight loading of light reflective material it is possible to generate the same color and intensity of light using a phosphor conversion layer **118** that comprises about 33% less phosphor material. Oval **134** indicates that the same intensity and color of emission product is produced for a phosphor conversion layer comprising i) 4 print passes without light reflective material and ii) 3 print passes with a 0.4% loading of light reflective material. These data indicate that for this embodiment, by the inclusion of a 0.4% weight loading of light reflective material, the same color and intensity of light can be produced using a phosphor conversion layer comprising about 25% less phosphor. Oval **136** indicates that the same intensity and color of emission product is produced for a phosphor conversion layer comprising i) 4 print passes without light reflective material and ii) 3 print passes with a 1.1% loading of light reflective material. These data indicate that by the inclusion of a 1.1% weight loading of light reflective material the same color and intensity of light can be produced using a phosphor conversion layer comprising about 25% less phosphor. Oval **138** indicates that the same intensity and color of emission product is produced for a phosphor conversion layer comprising i) 4 print passes with a 0.4% weight loading of light reflective material and ii) 3 print passes with a 2% weight loading of light reflective material. These data indicate by the inclusion of a 0.4% weight loading of light reflective material that the same color and intensity of light can be produced using a phosphor conversion layer comprising about 25% less phosphor. Points **140** (n=4, 1.1% loading) and **142** (n=4, 2% loading) suggest that a saturation point exists above which an increase in light reflective material loading results in a decrease in emission intensity with little effect on the color.

It is envisioned in further embodiments to incorporate the mixture of phosphor and light reflective material mixture within a light transmissive window. For example the phosphor and light reflective material mixture can be mixed with a light transmissive polymer and the polymer/phosphor mixture extruded or injection molded to form the wavelength conversion component **36** with the phosphor and light reflective material homogeneously distributed throughout the volume of the component.

The light scattering material **122** comprises a powdered material with a high reflectivity typically a reflectance of 0.9 or higher. The particle size of the light reflective material is typically in a range 0.1μm to 10μm and in a preferred embodiment is within a range 0.1μm to 10μm. The weight percent loading of light reflective material to phosphor material is in a range 0.1% to 10% and in a preferred embodiment in a range 1% to 2%. Examples of light reflective materials include magnesium oxide (MgO), titanium dioxide ($TiO_2$), barium sulfate ($BaSO_4$) and combinations thereof. The light reflective material can also comprise a white ink such as for example Norcote International Inc's super white ink GN-027SA which already includes particles of a highly light reflective material, typically $TiO_2$.

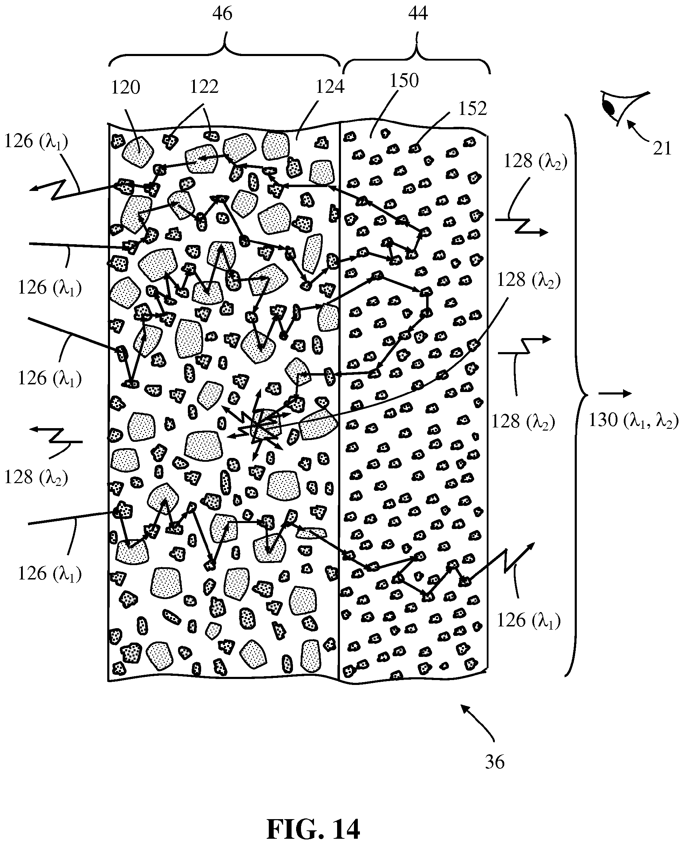

FIG. **14** illustrates a representation of a LED-based white light emitting device in accordance with an embodiment of the invention, which includes a wavelength conversion component **36** having a wavelength conversion layer **46** that includes a mixture of phosphor material particles **120** and light scattering particles **122** distributed throughout the volume of a light transmissive binder material **124**. The particles of light scattering particles **122** increase the probability of photons striking phosphor material particles **120,** and thus for an emission product of a given color less phosphor material is required.

Wavelength conversion component **36** also includes a diffusing layer **44** that comprises light scattering particles **152** within a binder material **150**. The light scattering particles **152** within the light diffusing layer **44** selectively scatters blue light **126** generated by the LEDs more than it scatters light **128** generated by the phosphor material **120**. Such a light diffusing layer **44** ensures that a higher proportion of the blue light **126** emitted from the wavelength conversion layer **46** will be scattered and directed by the light scattering material **152** back into the wavelength conversion layer **46** increasing the probability of the photon interacting with a phosphor material particle **120** and resulting in the generation of photoluminescence light. At the same time phosphor generated light can pass through the diffusing layer **44** with a lower probability of being scattered. Since the diffusing layer **44** increases the probability of blue photons interacting with a phosphor material particle **120**, less phosphor material can be used to generate an emitted light **130** of a selected emission color that is visible to an observer **21**.

Therefore, the combination of a diffusing layer **44** having scattering particles **152** and a wavelength conversion layer **46** that also includes light scattering particles **122** results in a wavelength conversion component that requires much less phosphor materials **120** to generate a given color emission product. Both sets of scattering particles **122** and **152** act in combination to increase the probability of photons striking a particle of phosphor material **120**, and thus require less phosphor material for a given color.

The two sets of scattering particles **122** and **152** can have different material properties. For example, the scattering particles **122** within the wavelength conversion layer **46** can be selected to have a relatively larger average particle size. On the other hand, the scattering particles **152** within the diffusing layer **44** can be selected to be nano-particles having a relatively smaller average particle size that is selected such that the particles **152** will scatter excitation (typically blue) light relatively more than they will scatter light generated by the photoluminescence (phosphor) material(s). Therefore, some embodiments employ a light scattering material **152** that has an average particle size of less than about 150nm and typically has an average particle size in a range of 100nm to 150nm. Alternative embodiments can implement both sets of scattering particles **122** and **152** having the same or substantially the same particle size, e.g. to employ nano-particles in both the wavelength conversion layer **46** and the diffusing layer **44.**

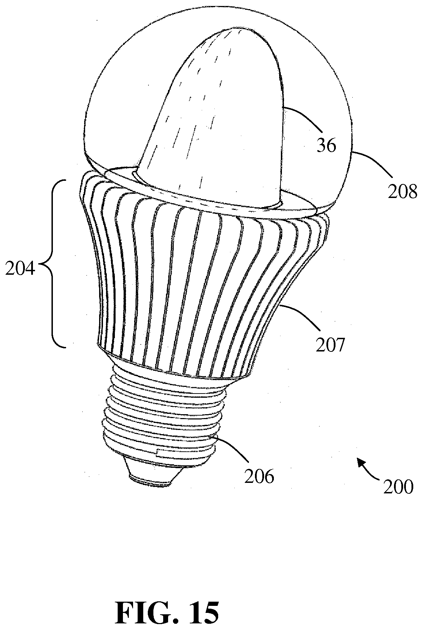

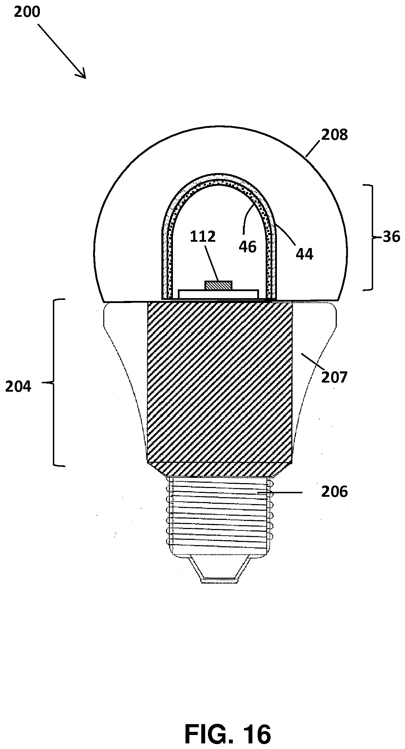

The inventive concepts disclosed herein may be applied to wavelength conversion components that encompass any suitable shape. For example, consider the LED light bulb **200** illustrated in FIGS. **15** and **16** which illustrate a perspective view and a cross-sectional view of an application of an LED light bulb that utilizes a wavelength conversion component in accordance with some embodiments. The LED light bulb **200** is intended to be used as an energy efficient replacement for a conventional incandescent or fluorescent light bulb.

The light bulb **200** comprises a screw base **206** that is configured to fit within standard light bulb sockets, e.g. implemented as a standard Edison screw base. The light bulb **200** may further comprise a thermally conductive body **204** fabricated from, for example, die cast aluminum. The body **204** functions as a heat sink and dissipates heat generated by the light emitters **112**, which are mounted on a MCPCB (Metal Core Printed Circuit Board). To increase heat radiation from the light bulb **200** and thereby increase cooling of the light bulb **200**, the body **204** can include a series of latitudinal radially extending heat radiating fins **207**.

The light bulb **200** further comprises a wavelength conversion component **36** having a three-dimensional shape, e.g. elongated dome shape shell having an interior volume defined by its inner surface that encloses the light emitters **112** within the interior volume. The three dimensional wavelength conversion component **36** includes a three-dimensional light transmissive thermally conductive substrate **703** in thermal contact with a three-dimensional wavelength conversion layer **701.**

An envelope **208** extends around the upper portion of the LED light bulb **200**, enclosing the LEDs **112** and the wavelength conversion component **36**. The envelope **208** is a light-transmissive material (e.g. glass or plastic) that provides protective and/or diffusive properties for the LED light bulb **200.**

The blue LED device **112** resides on the top surface of the lighting base **204**, beneath the wavelength conversion component **36**, which comprises both a light diffusing layer **44** and a wavelength conversion layer **46**. The three-dimensional nature of the wavelength conversion component **36** creates a relatively large shape that surrounds the interior volume around and above the LEDs **112**. Using three-dimensional shapes for the wavelength conversion component **36** in a lighting device **200** allows for certain functional advantages, such as the ability to perform light shaping for the light emitted by the lighting device **200.**

However, these types of three-dimensional shapes for the wavelength conversion component **36** also correspond to a relatively large volume for the wavelength conversion component which needs to be populated with adequate amounts of the phosphor materials. With prior art approaches, a significantly large amount of phosphor material would therefore be required to manufacture such wavelength conversion components **36.**

Embodiments of the invention may be employed to reduce the amount of phosphor needed to manufacture such wavelength conversion components **36**. In particular, the wavelength conversion component **36** comprises a light diffusing layer **44** that is adjacent to a wavelength conversion layer **46**, where either or both of these layers may include a light scattering material. Since the scattering material within the wavelength conversion component **36** has the property of scattering light, this reduces the amount of phosphor material that is needed for the wavelength conversion component **36.**

In addition, the light diffusing layer **44** also serves to improve the OFF state color appearance of the LED lighting device **200** based at least in part on the properties of the particles of diffracting materials within the diffusing layer **44.**

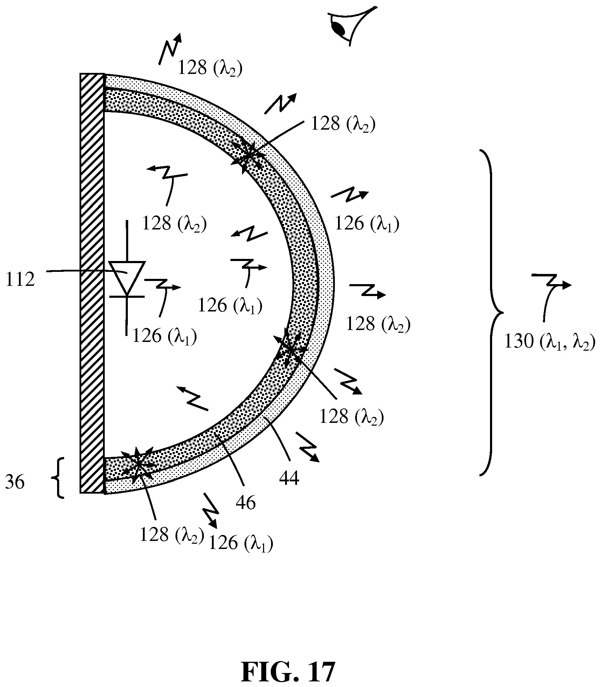

FIG. **17** illustrates an embodiment of the invention comprising a dome-shaped wavelength conversion component **36** that includes a light diffusing layer **44** adjacent to a wavelength conversion layer **46**, where either or both the light diffusing layer **44** and the wavelength conversion layer **46** comprise light scattering particles. As with the other described embodiments, the light scattering particles within the light diffusing layer **44** scatters blue light **126** generated by the LEDs **112** more than it scatters light **128** generated by the phosphor material within the wavelength conversion layer **46**, which ensures that a higher proportion of the blue light **126** emitted from the wavelength conversion layer **46** will be scattered and directed by the light scattering material **152** back into the wavelength conversion layer **46** increasing the probability of the photon interacting with a phosphor material particles and resulting in the generation of photoluminescence light. At the same time phosphor generated light can pass through the diffusing layer **44** with a lower probability of being scattered. Since the diffusing layer **44** increases the probability of blue photons interacting with a phosphor material particle, less phosphor material can be used to generate an emitted light **130** of a selected emission color that is visible to an observer **21**.

The three-dimensional wavelength conversion components of FIGs. **15-17** can be manufactured using any suitable means. For example, a molding process (e.g. injection molding) can be used to manufacture the two layers of the light diffusing layer **44** and the wavelength conversion layer **46**. For the light diffusing layer **44**, light diffractive material may be mixed with a solid light-transmissive polymer material, in which the phosphor material and the light-transmissive polymer material undergo a heating process that melts and mixes the phosphor material with the polymer material into a liquid, which is then injected into a mold and then cooled to form the final shape of the light diffusing layer **44**. For the wavelength conversion layer **46**, a similar molding process may be utilized, in which the phosphor material and the light-transmissive polymer material are heated and drawn into a mold (e.g. the light diffusing layer **44**). A heating process will melt and mix the phosphor material with the polymer material, which is then cooled to form the final shape of the wavelength conversion layer **46**. Hot runners may be employed to ensure efficient usage of the constituent components for the molding process. Vacuum molding may also be employed to manufacture the three-dimensional wavelength conversion components. In addition, light scattering particles may be introduced into the materials of the wavelength conversion layer **46**, thereby reducing the amount of phosphor material that is required.

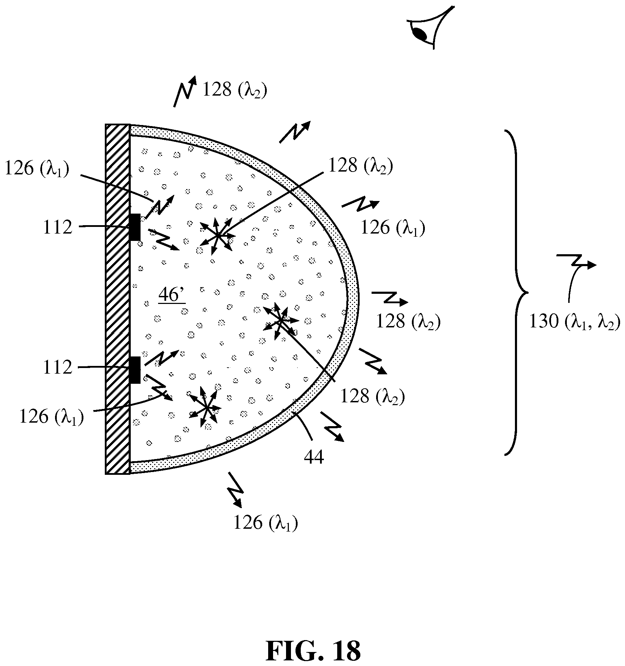

FIG. **18** illustrates an a three-dimensional wavelength conversion component **36** that includes a dome-shaped light diffusing layer **44**. The wavelength conversion layer **46'** fills a substantial portion of the volume defined by the interior surface of the light diffusing layer **44**, rather than being embodied as a thin layer directly adjacent to the light diffusing layer **44** as described in FIG. **17.** One possible advantage of the approach of FIG. **17** over the approach of FIG. **18** is the increased conversion efficiency for converting the blue light **126** generated by the LEDs **112** into the light **128** generated by the phosphor material within the wavelength conversion layer **46'**. However, a possible disadvantage is the negative performance that may result from excessive heating of the phosphor material within the wavelength conversion layer **46'** due to its close proximity to the LEDs **112**.

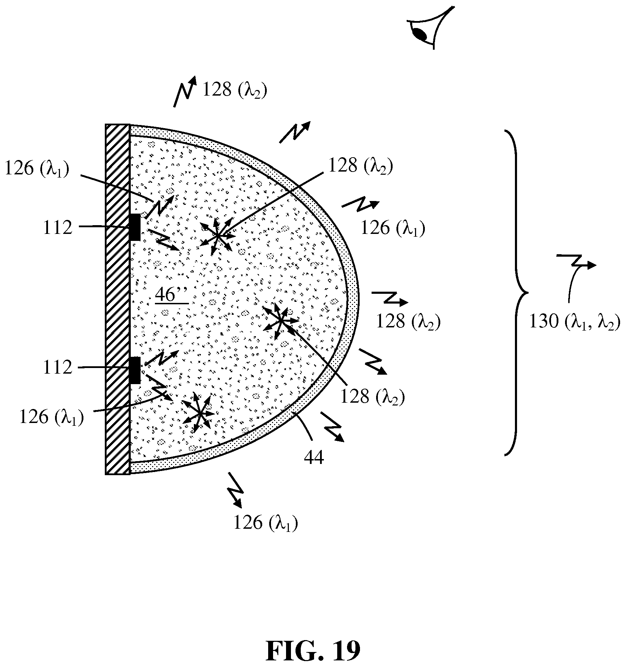

FIG. **19** illustrates a wavelength conversion component **36** with a dome-shaped light diffusing layer **44**. The wavelength conversion layer **46"** fills a substantial portion of the volume defined by the light diffusing layer **44**, but in which scattering particles are also distributed within the wavelength conversion layer **46"**. The scattering particles within the wavelength conversion layer **46"** has the property of scattering light, which reduces the amount of phosphor material that is needed for the wavelength conversion component **36.** In addition, the light diffractive material within the light diffusing layer **44** serves to improve the OFF state color appearance of the LED lighting device **200**, while also reducing the amount of phosphor material required for the wavelength conversion layer **46"**.

The wavelength conversion components of FIGs. **18** and **19** can be manufactured using any suitable means. For example, a molding process (e.g. injection molding or vacuum molding) can be used to manufacture the light diffusing layer **44**. For the light diffusing layer **44**, light diffractive material may be mixed with a solid light-transmissive polymer material (e.g. in the form of polymer pellets), which are heated and injected into a mold in the desired shape for the light diffusing layer **44**. The heating process will melt and mix the light diffractive material with the polymer material in the mold, which is then cooled to form the final shape of the light diffusing layer **44.** For the wavelength conversion layer, the phosphor material may be mixed with a liquid binder material, with the resulting mixture poured into the interior volume formed by the inner surfaces of the light diffusing layer **44**. A curing process is then employed to cure the wavelength conversion layer not its final form. Scattering particles may also be placed into the phosphor/binder mixture to reduce the amount of phosphor that is required.

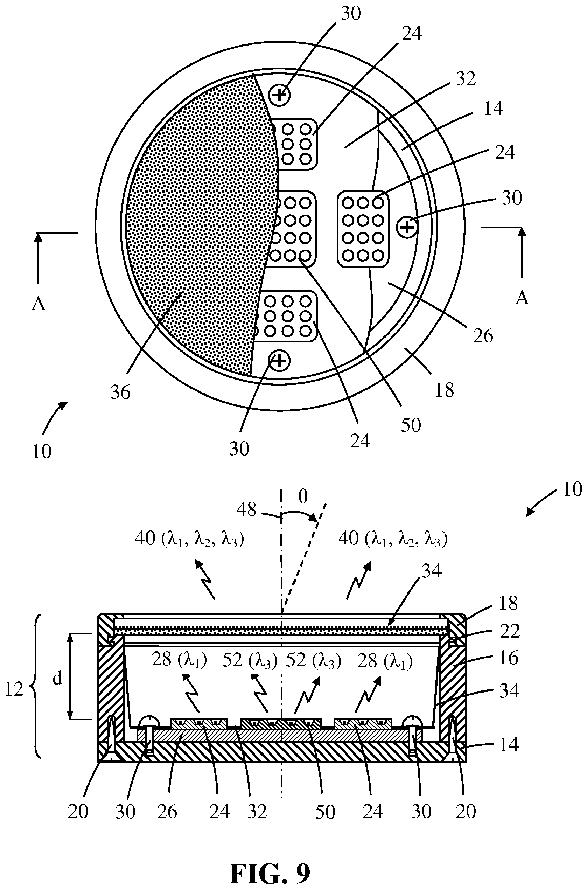

A high CRI solid-state light emitting device **10** in accordance with another embodiment of the invention will now be described with reference to FIG. **9** which shows schematic partial cutaway plan and sectional views of the device. The device **10** is configured to generate warm white light with a CCT of ≈3000K, a luminous flux of about 1100 lumens and a CRI (Color Rendering Index) greater than 90. The device **10** is essentially the same as that of FIG. **1** and additionally comprises one or more red light emitting LEDs (red LEDs) **50**. As shown in FIG. **9** the red LED(s) can comprise a packaged array of red LED chips. The red LED chips can comprise AlGaAs (aluminum gallium arsenic), GaAsP (gallium arsenic phosphide), AlGaInP (aluminum gallium indium phosphide) or GaP (gallium phosphide) LED that are operable to generate red light **52** having a peak wavelength $\lambda_3$ in a wavelength range 610nm to 670nm. The emission product **38** of the device **10** comprises the combined blue **28** ($\lambda_1$) and red **52** ($\lambda_3$) light by generated by the LEDs **24, 50** and photoluminescence light **38** generated by the phosphor wavelength conversion component **36**. Operation of the device **10** of FIG. **9** is analogous to that of the device of FIG. **1** and is not described further. Initial tests of the device of FIG. **9** indicate that the light diffusing layer **44** increases the angular emission color uniformity of the device by blending the red, blue and phosphor generated light.

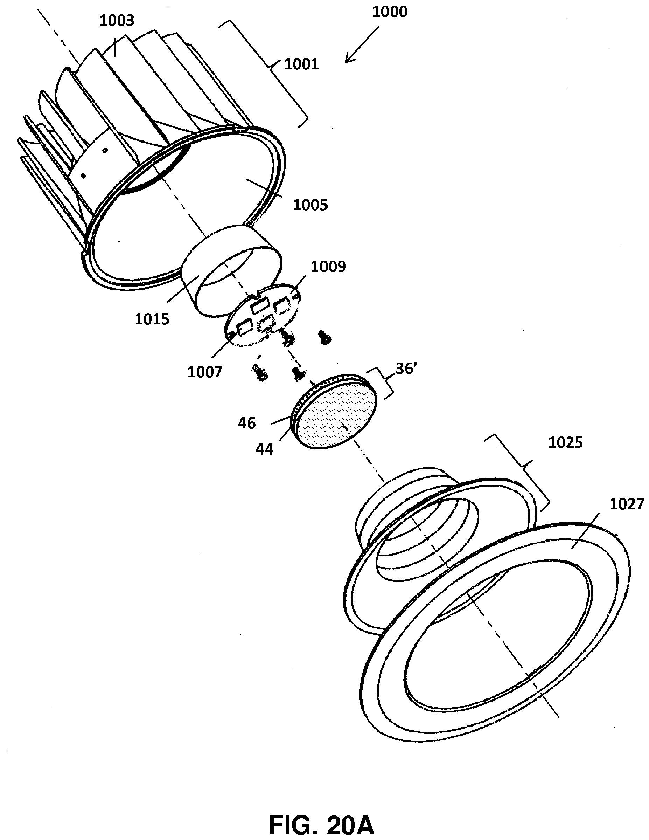

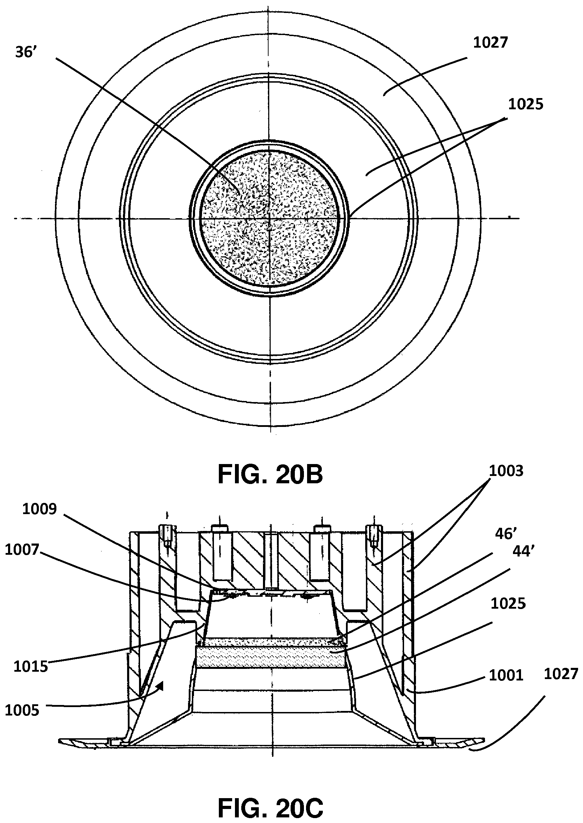

FIGs. **20A**, **20B**, and **20C** illustrate an example of an application of a wavelength conversion component in accordance with some embodiments of the invention. FIG. **20A**, **20B**, and **20C** illustrates an LED downlight **1000** that utilizes remote wavelength conversion in accordance with some embodiments. FIG. **20A** is an exploded perspective view of the LED downlight **1000,** FIG. **20B** is an end view of the downlight **1000,** and FIG. **20C** is a sectional view of the downlight **1000.** The downlight **1000** is configured to generate light with an emission intensity of 650-700 lumens and a nominal beam spread of 60° (wide flood). It is intended to be used as an energy efficient replacement for a conventional incandescent six inch downlight.

The downlight **1000** comprises a hollow generally cylindrical thermally conductive body **1001** fabricated from, for example, die cast aluminum. The body **1001** functions as a heat sink and dissipates heat generated by the LEDs **1007.** To increase heat radiation from the downlight **1000** and thereby increase cooling of the light emitting device **1000,** the body **1001** can include a series of latitudinal spirally extending heat radiating fins **1003** located towards the base of the body **1001.** To further increase the radiation of heat, the outer surface of the body can be treated to increase its emissivity such as for example painted black or anodized. The body **1001** further comprises a generally frusto-conical (i.e. a cone whose apex is truncated by a plane that is parallel to the base) axial chamber **1005** that extends from the front of the body a depth of approximately two thirds of the length of the body. The form factor of the body **1001** is configured to enable the downlight to be retrofitted directly in a standard six inch downlighting fixture (can) as are commonly used in the United States.

Four solid state light emitters **1007** are mounted as a square array on a circular shaped MCPCB **1009.** As is known an MCPCB comprises a layered structure composed of a metal core base, typically aluminum, a thermally conducting/electrically insulating dielectric layer and a copper circuit layer for electrically connecting electrical components in a desired circuit configuration. With the aid of a thermally conducting compound such as for example a standard heat sink compound containing beryllium oxide or aluminum nitride the metal core base of the MCPCB **1009** is mounted in thermal communication with the body via the floor of the chamber **1005.** The MCPCB **1009** can be mechanically fixed to the body floor by one or more screws, bolts or other mechanical fasteners.

The downlight **1000** further comprises a hollow generally cylindrical light reflective chamber wall mask **1015** that surrounds the array of light emitters **1007.** The chamber wall mask **1015** can be made of a plastics material and preferably has a white or other light reflective finish. A wavelength conversion component **36** may be mounted overlying the front of the chamber wall mask **1015** using, for example, an annular steel clip that has resiliently deformable barbs that engage in corresponding apertures in the body. The wavelength conversion component **36** is remote to the light emitting devices **1007.**

The wavelength conversion component **36** comprises a light diffusing layer **44** adjacent to a wavelength conversion layer **46** as described above. By placing the wavelength conversion layer **46** adjacent to a light diffusing layer **44**, the light scattering particles within the light diffusing layer **44** scatters blue light generated by the light emitters **1007** more than it scatters light generated by the phosphor material within the wavelength conversion layer **46.** This ensures that a higher proportion of the blue light emitted from the wavelength conversion layer **46** will be scattered and directed by the light scattering material back into the wavelength conversion layer **46** increasing the probability of the photon interacting with a phosphor material particles and resulting in the generation of photoluminescence light. At the same time phosphor generated light can pass through the diffusing layer **44** with a lower probability of being scattered. Since the diffusing layer **44** increases the probability of blue photons interacting with a phosphor material particle, less phosphor material can be used to generate an emitted light of a selected emission color. In addition, during its OFF state, the diffusing layer **44** also serves to improve the white color of the light **1000.**

The downlight **1000** further comprises a light reflective hood **1025** which is configured to define the selected emission angle (beam spread) of the downlight (i.e. 60° in this example). The hood **1025** comprises a generally cylindrical shell with three contiguous (conjoint) inner light reflective frusto-conical surfaces. The hood **1025** is preferably made of Acrylonitrile butadiene styrene (ABS) with a metallization layer. Finally the downlight **1025** can comprise an annular trim (bezel) **1027** that can also be fabricated from ABS.

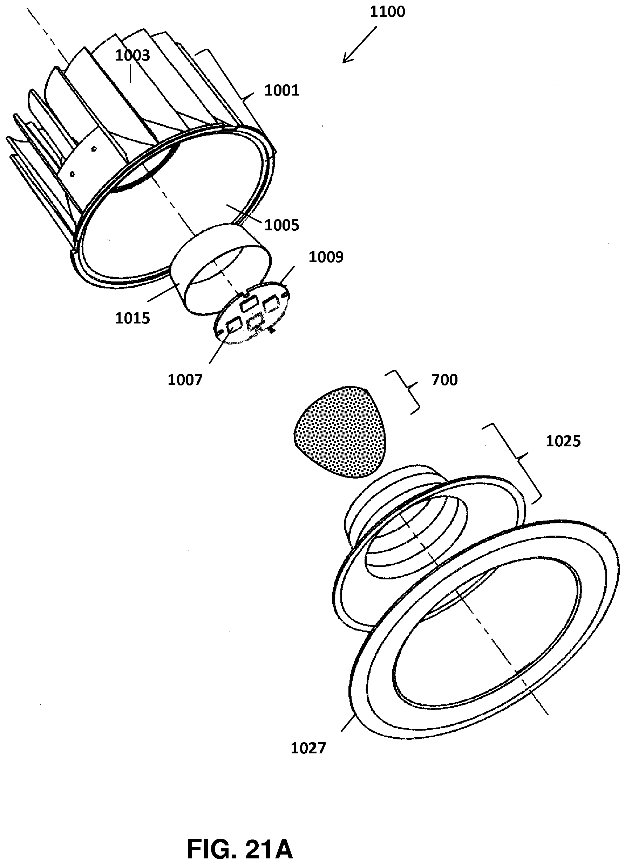

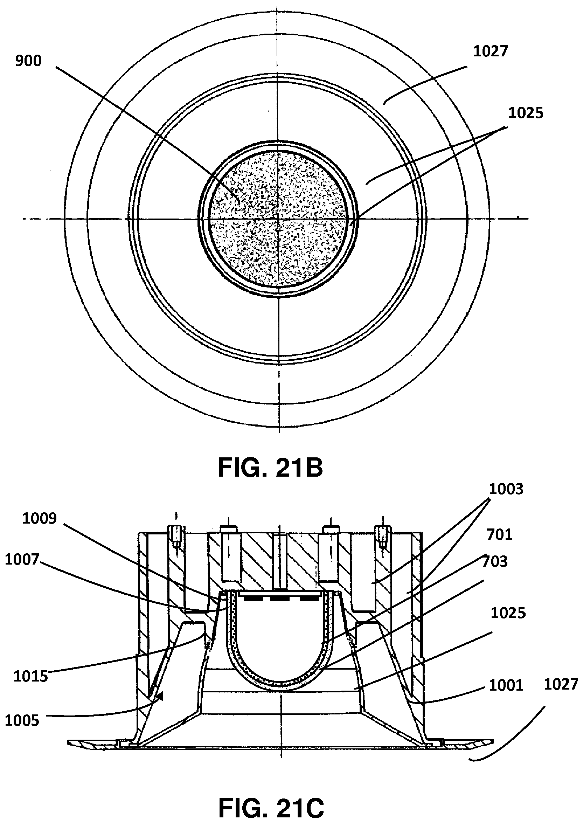

FIGs. **21A**, **21B**, and **21C** illustrate another example of an application of a wavelength conversion component in accordance with some embodiments. FIGs. **21A**, **21B**, and **21C** illustrate an LED downlight **1100** that utilizes remote wavelength conversion in accordance with some embodiments. FIG. **21A** is an exploded perspective view of the LED downlight **1100**, FIG. **21B** is an end view of the downlight **1100**, and FIG. **21C** is a sectional view of the downlight **1100.** The downlight **1100** is configured to generate light with an emission intensity of 650-700 lumens and a nominal beam spread of 60° (wide flood). It is intended to be used as an energy efficient replacement for a conventional incandescent six inch downlight.

The downlight **1100** of FIGs. **21A**, **21B**, and **21C** is substantially the same as the downlight **1000** of FIGs. **20A**, **20B**, and **20C.** For purposes of discussion, only features of the downlight **1100** that are new relative to the embodiments of FIGs. **20A**, **20B**, and **20C** will be described.

Whereas the wavelength conversion component **36** of FIGs. **20A**, **20B**, and **20C** has a two-dimensional shape (e.g. is substantially planar), the wavelength conversion component **700** of FIGs. **21A**, **21B**, and **21C** has a three-dimensional shape (e.g. elongated dome shaped shell). The three dimensional wavelength conversion component **700** includes a three-dimensional light transmissive thermally conductive substrate **703** in thermal contact with a three-dimensional wavelength conversion layer **701**, such as the wavelength conversion component **700** described above in FIG. **7**. The wavelength conversion component may also be mounted enclosing the front of the chamber wall mask **1015**.

As discussed above, by placing the wavelength conversion layer **701** adjacent to a light diffusing layer **703**, the light scattering particles within the light diffusing layer **703** scatters blue light generated by the light emitters **1007** more than it scatters light generated by the phosphor material within the wavelength conversion layer **701**. This ensures that a higher proportion of the blue light emitted from the wavelength conversion layer **701** will be scattered and directed by the light scattering material back into the wavelength conversion layer **700** increasing the probability of the photon interacting with a phosphor material particles and resulting in the generation of photoluminescence light. Therefore, less phosphor material is required to generate an emitted light of a selected emission color. In addition, during its OFF state, the diffusing layer **703** also improves the white color of the light **1100**.

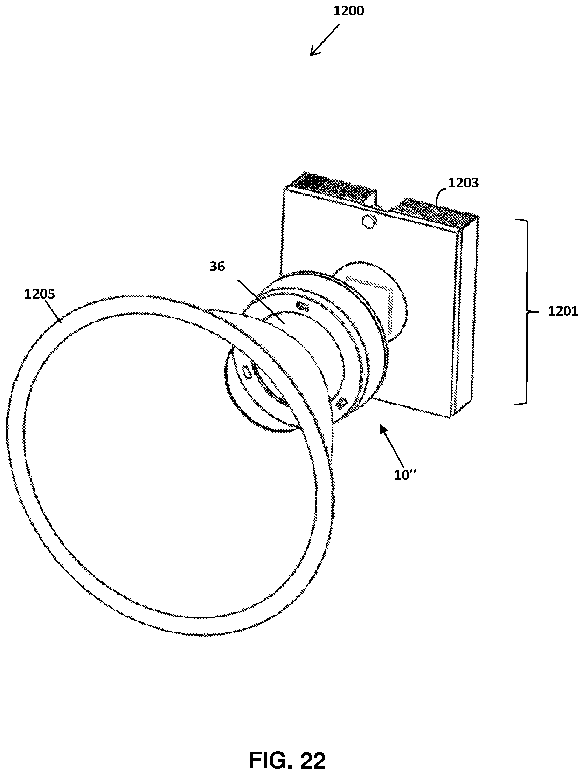

FIG. **22** illustrates another example of an application of a wavelength conversion component in accordance with some embodiments, showing an exploded perspective view of a reflector lamp **1200** that utilizes remote wavelength conversion in accordance with some embodiments. The reflector lamp **1200** is configured to generate light with an emission intensity of 650-700 lumens and a nominal beam spread of 60° (wide flood). It is intended to be used as an energy efficient replacement for a conventional incandescent six inch downlight.

The reflector lamp **1200** comprises a generally rectangular thermally conductive body **1201** fabricated from, for example, die cast aluminum. The body **1201** functions as a heat sink and dissipates heat generated by the light emitting device **10"** To increase heat radiation from the reflector lamp **1000** and thereby increase cooling of the light emitting device **10"**, the body **1201** can include a series of heat radiating fins **1203** located on the sides of the body **1201**. The form factor of the body **1201** is configured to enable the reflector lamp to be retrofitted directly in a standard six inch downlighting fixture (a "can") as are commonly used in the United States.

The wavelength conversion component 36 may be implemented to have a wavelength conversion layer that is adjacent to a light diffusing layer, such that the light scattering particles within the light diffusing layer scatters blue light more than it scatters light generated by the phosphor material within the wavelength conversion layer. Therefore, less phosphor material is required to generate an emitted light of a selected emission color. In addition, during its OFF state, the diffusing layer also improves the white color of the light **1200**.

The reflector lamp **1200** further comprises a generally frustro-conical light reflector **1205** having a paraboloidal light reflective inner surface which is configured to define the selected emission angle (beam spread) of the downlight (i.e. 60° in this example). The reflector **1205** is preferably made of Acrylonitrile butadiene styrene (ABS) with a metallization layer.

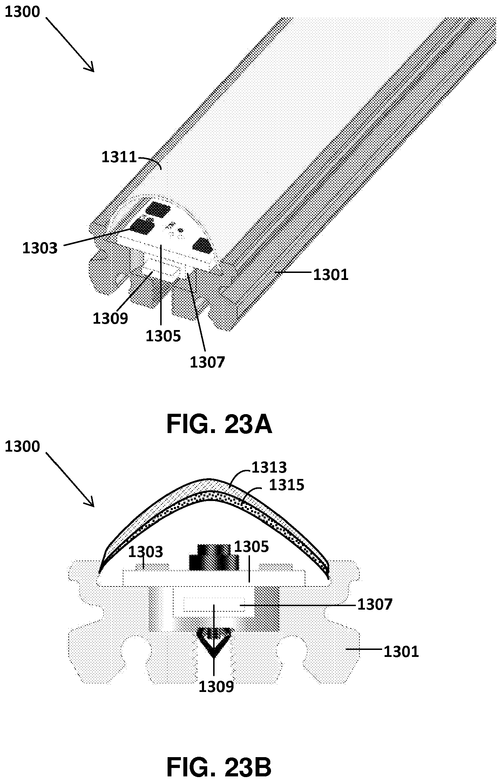

FIGs. **23A** and **23B** illustrate another example of an application of a wavelength conversion component in accordance with some embodiments. FIGs. **23A** and **23B** illustrate an LED linear lamp **1300** that utilizes remote wavelength conversion in accordance with some embodiments. FIG. **23A** is a three-dimensional perspective view of the linear lamp **1300** and FIG. **23B** is a cross-sectional view of the linear lamp **1300**. The LED linear lamp **1300** is intended to be used as an energy efficient replacement for a conventional incandescent or fluorescent tube lamp.

The linear lamp **1300** comprises an elongated thermally conductive body **1301** fabricated from, for example, extruded aluminum. The form factor of the body **1301** can be configured to be mounted with a standard linear lamp housing. The body **1301** further comprises a first recessed channel **1304**, wherein a rectangular tube-like case **1307** containing some electrical components (e.g. electrical wires) of the linear lamp **1300** may be situated. The case **1307** may further comprise an electrical connector **1309** (e.g. plug) extending past the length of the body **1301** on one end, and a recessed complimentary socket (not shown) configured to receive a connector on another end. This allows several linear lamps **1300** to be connected in series to cover a desired area. Individual linear lamps **1300** may range from 1 foot to 6 feet in length.

The body **1301** functions as a heat sink and dissipates heat generated by the light emitters **1303**. To increase heat radiation from the linear lamp **1300** and thereby increase cooling of the light emitters **1303**, the body **1301** can include a series of heat radiating fins **1302** located on the sides of the body **1301**. To further increase heat radiation from the linear lamp **1300**, the outer surface of the body **1301** can be treated to increase its emissivity such as for example painted black or anodized.

Light emitters **1303** are mounted on a strip (rectangular shaped) MCPCB **1305** configured to sit above the first recessed channel **1304**. The under surface of the MCPCB **1305** sits in thermal contact with a second recessed channel **1306** that includes inclined walls **1302**.

A generally hemi-spherical elongate wavelength conversion component **1311** may be positioned remote to the light emitters **1303**. The wavelength conversion component **1311** may be secured within the second recessed channel **1306** by sliding the wavelength conversion component **1311** under the inclined walls **1308** such that the wavelength conversion component **1311** engages with inclined walls **1308.**

The wavelength conversion component **1311** may include a hemi-spherical elongate light diffusing layer **1313** and a hemi-spherical elongate wavelength conversion layer **1315.** As discussed above, less phosphor material is required to generate an emitted light of a selected emission color. In addition, during its OFF state, the diffusing layer also improves the white color of the light **1300.**

In alternative embodiments, the wavelength conversion component of the linear lamp may be configured in the shape of a generally planar strip. In such embodiments, it will be appreciated that the second recessed channel may instead have vertical walls that extend to allow the wavelength conversion component to be received by the second recessed channel.

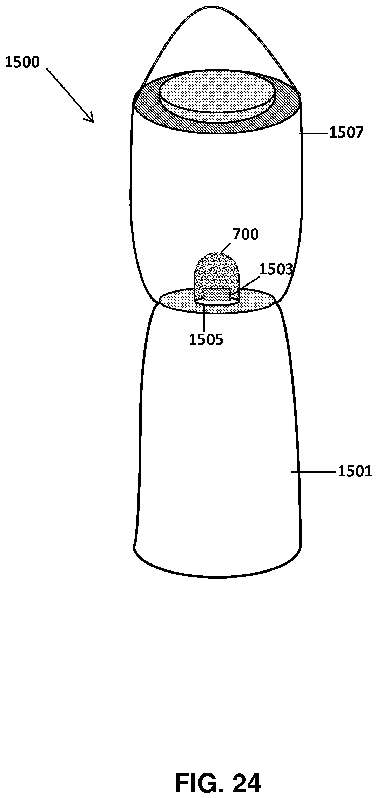

FIG. **24** illustrates a perspective of another application of a wavelength conversion component in accordance with some embodiments. FIG. **24** illustrates an LED lantern **1500** that utilizes remote wavelength conversion. The LED light lantern **1500** is intended to be used as an energy efficient replacement for conventional gas and fluorescent lanterns (e.g. camping lanterns).

The lantern **1500** comprises a generally cylindrical thermally conductive body **1501** fabricated from, for example, plastic material or pressed metal. The body **1501** further includes an internal heat sink which dissipates heat generated by the light emitters **1503**, which are mounted on a circular shaped MCPCB **1505.** The MCPCB **1505** may be in thermal contact with the body **1501.**

The lantern **1500** comprises a three-dimensional (e.g. elongated dome shaped shell) wavelength conversion component **700**, such as the one described above in FIG. **17**, **18** or **19**, that extends from the MCPCB **1505.** While only an exterior surface of the wavelength conversion component **700** is depicted, it is important to note that the three dimensional wavelength conversion component **700** may include a three-dimensional light diffusing layer adjacent to a three-dimensional wavelength conversion layer. As discussed above, this configuration permits less phosphor material to be used to generate an emitted light of a selected emission color. In addition, during its OFF state, the diffusing layer also improves the white color of the light.

A light transmissive cover (e.g. plastic) **1507** may extend around the upper portion of the lantern, surrounding the LEDs **1503** and the wavelength conversion component **900.** The light transmissive cover **1507** comprises a light-transmissive material (e.g. glass or plastic) that provides protective and/or diffusive properties for the LED lantern **1500.** The lantern **1500** may further comprise a lid that sits on top of the glass receptacle to enclose the light emitters **1503** and the wavelength conversion component **700.**

The above applications of light emitting devices describe a remote wavelength conversion configuration, wherein a wavelength conversion component is remote to one or more light emitters. The wavelength conversion component and body of those light emitting devices define an interior volume wherein the light emitters are located. The interior volume may also be referred to as a light mixing chamber. For example, in the downlight **1000, 1100** of FIGs. **20A**, **20B**, **20C**, **21A**, **21B**, and **21C**, an interior volume **1029** is defined by the wavelength conversion component **36', 700**, the light reflective chamber mask **1015**, and the body of the downlight **1001.** In the linear lamp **1300** of FIGs. **23A** and **23B**, an interior volume **1325** is defined by the wavelength conversion component **1311** and the body of the linear lamp **1301.** In the light bulb **200** of FIGs. **15** and **16**, an interior volume **1415** is defined by the wavelength conversion component **36** and the body of the light bulb **204.** Such an interior volume provides a physical separation (air gap) of the wavelength conversion component from the light emitters that improves the thermal characteristics of the light emitting device. Due to the isotropic nature of photoluminescence light generation, approximately half of the light generated by the phosphor material can be emitted in a direction towards the light emitters and can end up in the light mixing chamber. It is believed that on average as little as 1 in a 10,000 interactions of a photon with a phosphor material particle results in absorption and generation of photoluminescence light. The majority, about 99.99%, of interactions of photons with a phosphor particle result in scattering of the photon. Due to the isotropic nature of the scattering process on average half the scattered photons will be in a direction back towards the light emitters. As a result up to half of the light generated by the light emitters that is not absorbed by the phosphor material can also end up back in the light mixing chamber. To maximize light emission from the device and to improve the overall efficiency of the light emitting device the interior volume of the mixing chamber includes light reflective surfaces to redirect - light in- the interior volume towards the wavelength conversion component and out of the device. The light mixing chamber may be operated to mix light within the chamber. The light mixing chamber can be defined by the wavelength conversion component in conjunction with another component of the device such a device body or housing (e.g. dome-shaped wavelength conversion component encloses light emitters located on a base of device body to define light mixing chamber, or planar wavelength conversion component placed on a chamber shaped component to enclose light emitters located on a base of device body and surrounded by the chamber shaped component to define light mixing chamber). For example, the downlight **1000, 1100** of FIGs. **20A, 20B, 20C, 21A, 21B,** and **21C,** includes an MCPCB **1009,** on which the light emitters **1007** are mounted, comprising light reflective material and a light reflective chamber wall mask **1015** to facilitate the redirection of light reflected back into the interior volume towards the wavelength conversion component **36', 700.** The linear lamp **1300** of FIGs. **23A** and **23B** includes an MCPCB **1305,** on which the light emitters **1303** are mounted, comprising light reflective material to facilitate the redirection of light reflected back into the interior volume towards the wavelength conversion component **1311**. The light bulb **200** of FIGs. **12A** and **12B** also includes an MCPCB **1405** on which the light emitters **112** are mounted, to facilitate the redirection of light reflected back into the interior volume towards the wavelength conversion component **36**.

The above applications of light emitting devices describe only a few embodiments with which the claimed invention may be applied. It is important to note that the claimed invention may be applied to other types of light emitting device applications, including but not limited to, wall lamps, pendant lamps, chandeliers, recessed lights, track lights, accent lights, stage lighting, movie lighting, street lights, flood lights, beacon lights, security lights, traffic lights, headlamps, taillights, signs, etc.

Therefore, what has been described is a novel wavelength conversion component that comprises a light diffusing layer. Light diffractive particles within the light diffusing layer are selected to have a size such that the particles will scatter blue light generated by the LED relatively more than they will scatter light generated by a wavelength conversion layer, e.g. where the particles have an average particle size that is less than about 150nm. This approach of using the light diffusing layer in combination with the wavelength conversion layer solves the problem of variations or non-uniformities in the color of emitted light with emission angle. In addition, the color appearance of the lighting apparatus in its OFF state can be improved by implementing the light diffusing layer in combination with the wavelength conversion layer. Moreover, significant reductions can be achieved in the amount phosphor materials that is required to implement phosphor-based LED devices.

It will be appreciated that the invention is not limited to the exemplary embodiments described and that variations can be made within the scope of the invention. For example whilst the devices of the invention have been described as comprising one or more LEDs the devices can comprise other solid-state light sources such as a laser diode or laser.

**Claims**

1. A light emitting device (10), comprising:

    at least one solid-state light emitter (24) operable to generate blue excitation light; and
    a wavelength conversion component (36) positioned remotely to the at least one solid-state light emitter, said wavelength conversion component comprising: at least one blue light excitable photoluminescence material (120); and a light scattering material (152), wherein the light scattering material has an average particle size that is selected such that the light scattering material will scatter blue excitation light relatively more than the light scattering material will scatter light generated by the at least one photoluminescence material, wherein the at least one photoluminescence material is located in a wavelength conversion layer (46) and the light scattering material is located in a light diffusing layer (44) different from the wavelength conversion layer, and wherein the light scattering material has an average particle size in a range 100nm to 150nm and the wavelength conversion layer faces the at least one solid-state light emitter such that, in operation, the diffusing layer decreases the probability of externally originating photons from interacting with the at least one photoluminescence material thereby improving an OFF state white appearance of the component of the light emitting device.

2. The light emitting device (10) of Claim 1, wherein the light scattering material (152) scatters the excitation light at least twice as much as light generated by the at least one photoluminescence material.

3. The light emitting device (10) of any preceding claim, wherein the light scattering material (152) is selected from the group consisting of: titanium dioxide, barium sulfate, magnesium oxide, silicon dioxide and aluminum oxide.

4. The light emitting device (10) of any preceding claim, wherein the wavelength conversion layer (46) and the light diffusing layer (44) are in direct contact with each other.

5. The light emitting device (10) of any preceding claim, wherein the wavelength conversion layer (46) comprises a mixture of the at least one photoluminescence material and a light transmissive binder (124) and the light diffusing layer (44) comprises a mixture of the light scattering material and the light transmissive binder.

6. The light emitting device (10) of Claim 5, wherein the light transmissive binder (124) comprises a curable liquid polymer selected from the group consisting of: a polymer resin, a monomer resin, an acrylic, an epoxy, a silicone and a fluorinated polymer.

7. The light emitting device (10) of Claim 5 or Claim 6, wherein a weight loading of light scattering material (152) to a binder is selected from the group consisting of: 7% to 35% and 10% to 20%.

8. The light emitting device (10) of Claim 5, wherein the wavelength conversion and light diffusing layers (46/44) are deposited using a method selected from the group consisting of: screen printing, slot die coating, spin coating, roller coating, drawdown coating and doctor blading.

9. The light emitting device (10) of any preceding claim, wherein the wavelength conversion layer (46) and the light diffusing layer (44) are substantially planar.

10. The light emitting device (10) of any of Claims 1 to 8, wherein the light diffusing layer (44) comprises a dome or elongated dome shape.

11. The light emitting device (10) of Claim 10, wherein the wavelength conversion layer (46) fills a volume formed beneath the dome or elongated dome shapes.

12. The light emitting device (10) of any preceding claim, wherein the wavelength conversion layer comprises a mixture of the at least one blue light excitable photoluminescence material (120) and a light scattering material (122).

13. The light emitting device (10) of any preceding claim, wherein the light diffusing layer (44) is deposited onto a light transmissive substrate (42), and optionally the light transmissive substrate is selected from the group consisting of: a polycarbonate, an acrylic and a glass.

14. The light emitting device (10) of any of Claims 1 to 12, wherein the wavelength conversion layer is deposited onto a light transmissive substrate (42), and optionally the light transmissive substrate is selected from the group consisting of: a polycarbonate, an acrylic and a glass.

**Patentansprüche**

1. Lichtemittierende Vorrichtung (10), umfassend:

   mindestens einen Festkörper-Lichtemitter (24), der dazu betreibbar ist, blaues Anregungslicht zu erzeugen; und eine Wellenlängenkonversionskomponente (36), die entfernt von dem mindestens einen Festkörper-Lichtemitter positioniert ist, wobei die Wellenlängenkonversionskomponente umfasst: mindestens ein durch blaues Licht anregbares Photolumineszenzmaterial (120); und ein lichtstreuendes Material (152), wobei das lichtstreuende Material eine durchschnittliche Partikelgröße aufweist, die so ausgewählt ist, dass das lichtstreuende Material blaues Anregungslicht relativ stärker streuen wird als das lichtstreuende Material Licht streuen wird, das durch das mindestens eine Photolumineszenzmaterial erzeugt wird, wobei sich das mindestens eine Photolumineszenzmaterial in einer Wellenlängenkonversionsschicht (46) befindet und sich das lichtstreuende Material in einer Lichtdiffusionsschicht (44) befindet, die sich von der Wellenlängenkonversionsschicht unterscheidet, und wobei das lichtstreuende Material eine durchschnittliche Partikelgröße in einem Bereich zwischen 100 nm und 150 nm aufweist und die Wellenlängenkonversionsschicht dem mindestens einen Festkörper-Lichtemitter zugewandt ist, so dass die Diffusionsschicht im Betrieb die Wahrscheinlichkeit verringert, dass von außen stammende Photonen mit dem mindestens einen Photolumineszenzmaterial interagieren, und somit ein weißes Aussehen der Komponente der lichtemittierenden Vorrichtung im AUS-Zustand verbessert.

2. Lichtemittierende Vorrichtung (10) nach Anspruch 1, wobei das lichtstreuende Material (152) das Anregungslicht mindestens doppelt so viel streut wie Licht, das durch das mindestens eine Photolumineszenzmaterial erzeugt wird.

3. Lichtemittierende Vorrichtung (10) nach einem der vorstehenden Ansprüche, wobei das lichtstreuende Material (152) ausgewählt ist aus der Gruppe bestehend aus: Titandioxid, Bariumsulfat, Magnesiumoxid, Siliziumdioxid und Aluminiumoxid.

4. Lichtemittierende Vorrichtung (10) nach einem der vorstehenden Ansprüche, wobei die Wellenlängenkonversionsschicht (46) und die Lichtdiffusionsschicht (44) in direktem Kontakt miteinander sind.

5. Lichtemittierende Vorrichtung (10) nach einem der vorstehenden Ansprüche, wobei die Wellenlängenkonversionsschicht (46) eine Mischung aus dem mindestens einen Photolumineszenzmaterial und einem lichtdurchlässigen Bindemittel (124) umfasst und die Lichtdiffusionsschicht (44) eine Mischung aus dem lichtstreuenden Material und dem lichtdurchlässigen Bindemittel umfasst.

6. Lichtemittierende Vorrichtung (10) nach Anspruch 5, wobei das lichtdurchlässige Bindemittel (124) ein aushärtbares flüssiges Polymer umfasst, das ausgewählt ist aus der Gruppe bestehend aus: einem Polymerharz, einem Monomerharz, einem Acryl-, einem Epoxid-, einem Silikon- und einem fluorierten Polymer.

7. Lichtemittierende Vorrichtung (10) nach Anspruch 5 oder Anspruch 6, wobei eine Gewichtsbelastung des lichtstreuenden Materials (152) auf ein Bindemittel ausgewählt ist aus der Gruppe bestehend aus: 7 % bis 35 % und 10 % bis 20 %.

8. Lichtemittierende Vorrichtung (10) nach Anspruch 5, wobei die Wellenlängenkonversions- und die Lichtdiffusionsschicht (46/44) unter Verwendung eines Verfahrens abgeschieden werden, das ausgewählt ist aus der Gruppe bestehend aus: Siebdruck, Schlitzdüsenbeschichtung, Rotationsbeschichtung, Walzenbeschichtung, Abziehbeschichtung und Rakelbeschichtung.

9. Lichtemittierende Vorrichtung (10) nach einem der vorstehenden Ansprüche, wobei die Wellenlängenkonversionsschicht (46) und die Lichtdiffusionsschicht (44) im Wesentlichen eben sind.

10. Lichtemittierende Vorrichtung (10) nach einem der Ansprüche 1 bis 8, wobei die Lichtdiffusionsschicht (44) eine Kuppel- oder längliche Kuppelform umfasst.

11. Lichtemittierende Vorrichtung (10) nach Anspruch 10, wobei die Wellenlängenkonversionsschicht (46) ein Volumen füllt, das unter der Kuppel- oder länglichen Kuppelform gebildet wird.

12. Lichtemittierende Vorrichtung (10) nach einem der vorstehenden Ansprüche, wobei die Wellenlängenkonversionsschicht eine Mischung aus dem mindestens einen durch blaues Licht anregbaren Photolumineszenzmaterial (120) und einem lichtstreuenden Material (122) umfasst.

13. Lichtemittierende Vorrichtung (10) nach einem der vorstehenden Ansprüche, wobei die Lichtdiffusionsschicht (44) auf ein lichtdurchlässiges Substrat (42) abgeschieden wird und optional das lichtdurchlässige Substrat ausgewählt ist aus der Gruppe bestehend aus: einem Polycarbonat, einem Acryl und einem Glas.

14. Lichtemittierende Vorrichtung (10) nach einem der Ansprüche 1 bis 12, wobei die Wellenlängenkonversionsschicht auf ein lichtdurchlässiges Substrat (42) abgeschieden wird und optional das lichtdurchlässige Substrat ausgewählt ist aus der Gruppe bestehend aus: einem Polycarbonat, einem Acryl und einem Glas.

**Revendications**

1. Dispositif émetteur de lumière (10), comprenant :

au moins un émetteur de lumière à semi-conducteur (24) opérationnel pour générer une lumière d'excitation bleue ; et

un composant de conversion de longueur d'onde (36) positionné à distance de l'au moins un émetteur de lumière à semi-conducteur, ledit composant de conversion de longueur d'onde comprenant : au moins un matériau photoluminescent excitable par lumière bleue (120) ; et un matériau de dispersion de lumière (152), dans lequel le matériau de dispersion de lumière a une taille moyenne de particules qui est choisie de telle sorte que le matériau de dispersion de lumière dispersera une lumière d'excitation bleue relativement plus que le matériau de dispersion de lumière ne dispersera une lumière générée par l'au moins un matériau photoluminescent, dans lequel l'au moins un matériau photoluminescent est situé dans une couche de conversion de longueur d'onde (46) et le matériau de dispersion de lumière est situé dans une couche de diffusion lumineuse (44) différente de la couche de conversion de longueur d'onde, et dans lequel le matériau de dispersion de lumière a une taille moyenne de particules dans une plage de 100 nm à 150 nm et la couche de conversion de longueur d'onde fait face à l'au moins un émetteur de lumière à semi-conducteur de telle sorte que, en fonctionnement, la couche de diffusion diminue la probabilité que des photons d'origine extérieure n'interagissent avec l'au moins un matériau photoluminescent ce qui améliore une apparence blanche à l'état désactivé du composant du dispositif émetteur de lumière.

**2.** Dispositif émetteur de lumière (10) selon la revendication 1, dans lequel le matériau de dispersion de lumière (152) diffuse la lumière d'excitation au moins deux fois plus que la lumière générée par l'au moins un matériau photoluminescent.

**3.** Dispositif émetteur de lumière (10) selon une quelconque revendication précédente, dans lequel le matériau de dispersion de lumière (152) est choisi dans le groupe constitué de : dioxyde de titane, sulfate de baryum, oxyde de magnésium, dioxyde de silicium et oxyde d'aluminium.

**4.** Dispositif émetteur de lumière (10) selon une quelconque revendication précédente, dans lequel la couche de conversion de longueur d'onde (46) et la couche de diffusion lumineuse (44) sont en contact direct l'une avec l'autre.

**5.** Dispositif émetteur de lumière (10) selon une quelconque revendication précédente, dans lequel la couche de conversion de longueur d'onde (46) comprend un mélange de l'au moins un matériau photoluminescent et d'un liant laissant passer la lumière (124) et la couche de diffusion lumineuse (44) comprend un mélange du matériau de dispersion de lumière et du liant laissant passer la lumière.

**6.** Dispositif émetteur de lumière (10) selon la revendication 5, dans lequel le liant laissant passer la lumière (124) comprend un polymère liquide durcissable choisi dans le groupe constitué de : une résine polymère, une résine monomère, un acrylique, un époxy, une silicone et un polymère fluoré.

**7.** Dispositif émetteur de lumière (10) selon la revendication 5 ou la revendication 6, dans lequel une charge de poids de matériau de dispersion de lumière (152) à un liant est choisie dans le groupe constitué de : 7 % à 35 % et 10 % à 20 %.

**8.** Dispositif émetteur de lumière (10) selon la revendication 5, dans lequel les couches de conversion de longueur d'onde et de diffusion lumineuse (46/44) sont déposées en utilisant un procédé choisi dans le groupe constitué de : sérigraphie, revêtement par filière plate, revêtement par centrifugation, enduction, rabattement et raclage.

**9.** Dispositif émetteur de lumière (10) selon une quelconque revendication précédente, dans lequel la couche de conversion de longueur d'onde (46) et la couche de diffusion lumineuse (44) sont essentiellement planes.

**10.** Dispositif émetteur de lumière (10) selon l'une quelconque des revendications 1 à 8, dans lequel la couche de diffusion lumineuse (44) comprend une forme de dôme ou de dôme allongé.

**11.** Dispositif émetteur de lumière (10) selon la revendication 10, dans lequel la couche de conversion de longueur d'onde (46) remplit un volume formé en dessous des formes de dôme ou de dôme allongé.

**12.** Dispositif émetteur de lumière (10) selon une quelconque revendication précédente, dans lequel la couche de conversion de longueur d'onde comprend un mélange de l'au moins un matériau photoluminescent excitable par la lumière bleue (120) et d'un matériau de dispersion de lumière (122).

**13.** Dispositif émetteur de lumière (10) selon une quelconque revendication précédente, dans lequel la couche de diffusion lumineuse (44) est déposée sur un substrat laissant passer la lumière (42), et éventuellement le substrat laissant passer la lumière est choisi dans le groupe constitué de : un polycarbonate, un acrylique et un verre.

**14.** Dispositif émetteur de lumière (10) selon l'une quelconque des revendications 1 à 12, dans lequel la couche de conversion de longueur d'onde est déposée sur un substrat laissant passer la lumière (42), et éventuellement le substrat laissant passer la lumière est choisi dans le groupe constitué de : un polycarbonate, un acrylique et un verre.

**FIG. 1**

$40 \ (\lambda_1, \lambda_2)$

36

42

44

46

$t_1$

$t_2$

$t_3$

$38 \ (\lambda_2)$  $38 \ (\lambda_2)$  $38 \ (\lambda_2)$

$28 \ (\lambda_1)$  $28 \ (\lambda_1)$  $28 \ (\lambda_1)$

21

**FIG. 2**

21

$40 \ (\lambda_1, \lambda_2)$

44

46

42

$38 \ (\lambda_2)$  $38 \ (\lambda_2)$  $38 \ (\lambda_2)$

$t_2$

$t_3$

$t_1$

36

$28 \ (\lambda_1)$  $28 \ (\lambda_1)$  $28 \ (\lambda_1)$

**FIG. 3**

**FIG. 4**

**FIG. 5**

**FIG. 6**

**FIG. 7**

## CIE 1931 Chromaticity Diagram

**FIG. 8**

FIG. 9

**FIG. 10**

**PRIOR ART**

**FIG. 11**

**FIG. 12**

**FIG. 13**

**FIG. 14**

**FIG. 15**

200

208

36

112

46

44

204

207

206

# FIG. 16

**FIG. 17**

126 (λ₁)

112

46'

112

126 (λ₁)

128 (λ₂)

128 (λ₂)

126 (λ₁)

128 (λ₂)

128 (λ₂)

44

126 (λ₁)

130 (λ₁, λ₂)

**FIG. 18**

**FIG. 19**

**FIG. 20A**

36'

1027

1025

**FIG. 20B**

1003

1009

46'

44'

1007

1025

1015

1005

1001    1027

**FIG. 20C**

**FIG. 21A**

900

1027

1025

**FIG. 21B**

1003

1009

1007

701

703

1015

1025

1005

1001  1027

**FIG. 21C**

**1200**

**1203**

**1201**

**36**

**1205**

**10''**

**FIG. 22**

1300

1311

1303

1309

1305

1307

1301

## FIG. 23A

1300

1313
1315

1303

1305

1307

1301

1309

## FIG. 23B

**FIG. 24**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5998925 A
- US 2011147778 A
- EP 2113949 A
- US 6653765 B
- US 2011006316 A
- WO 2007085977 A
- US 2011001151 A
- US 7575697 B2
- US 7601276 B2
- US 7655156 B2
- US 7311858 B2
- US 20060158090 A1
- US 7390437 B2
- US 20080111472 A1
- US 20090283721 A1
- WO 2010074963 A1
- US 253031 A